(19) Europäisches Patentamt
European Patent Office
Office européen des brevets

(11) **EP 3 379 273 B1**

(12) **EUROPÄISCHE PATENTSCHRIFT**

(45) Veröffentlichungstag und Bekanntmachung des Hinweises auf die Patenterteilung:
**18.09.2019 Patentblatt 2019/38**

(51) Int Cl.:
***G01R 31/08*** *(2006.01)*

(21) Anmeldenummer: **17162355.6**

(22) Anmeldetag: **22.03.2017**

(54) **VERFAHREN, EINRICHTUNG UND SYSTEM ZUM ERMITTELN DES FEHLERORTES EINES FEHLERS AUF EINER LEITUNG EINES ELEKTRISCHEN ENERGIEVERSORGUNGSNETZES**

METHOD, DEVICE AND SYSTEM FOR DETERMINING THE LOCATION A FAULT ON A LINE OF AN ELECTRICAL ENERGY SUPPLY NETWORK

PROCÉDÉ, DISPOSITIF ET SYSTÈME DESTINÉS À LOCALISER UN DÉFAUT SUR UNE LIGNE D'UN RÉSEAU D'ALIMENTATION ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**26.09.2018 Patentblatt 2018/39**

(73) Patentinhaber: **Siemens Aktiengesellschaft 80333 München (DE)**

(72) Erfinder:
• **Dzienis, Cezary**
  **14624 Dallgow-Döberitz (DE)**
• **Jurisch, Andreas**
  **16727 Schwante (DE)**

(56) Entgegenhaltungen:
**CH-A5- 684 660        US-A- 3 590 368**
**US-A- 4 183 072        US-A1- 2011 109 465**
**US-A1- 2014 074 414    US-A1- 2015 081 235**

**Beschreibung**

Die Erfindung betrifft ein Verfahren zum Ermitteln des Fehlerortes eines Fehlers auf einer Leitung eines elektrischen Energieversorgungsnetzes, bei dem an einem ersten Leitungsende der Leitung erste Strom- und Spannungswerte gemessen und mit einem Zeitstempel versehen werden, an einem zweiten Leitungsende der Leitung zweite Strom- und Spannungswerte gemessen und mit einem Zeitstempel versehen werden, und unter Verwendung der zeitgestempelten ersten und zweiten Strom- und Spannungswerte nach dem Auftreten eines Fehlers auf der Leitung dessen Fehlerort bestimmt wird.

Die Erfindung betrifft auch eine entsprechende Einrichtung sowie ein System zum Ermitteln des Fehlerortes eines Fehlers auf einer Leitung eines elektrischen Energieversorgungsnetzes.

Der sichere Betrieb elektrischer Energieversorgungsnetze erfordert die schnelle und zuverlässige Erkennung und Abschaltung etwaiger Fehler, wie z.B. Kurzschlüssen oder Erdschlüssen. Fehlerursachen, die eine Abschaltung bewirken, können beispielsweise Blitzeinschläge, gerissene oder anderweitig schadhafte Leitungen, fehlerhafte Isolierungen bei Kabelleitungen oder die ungewollte Berührung von Freileitungen mit Tier- oder Pflanzenteilen sein. Zur Verkürzung von fehlerbedingten Ausfallzeiten müssen solche Fehler möglichst genau lokalisiert werden, um eine Behebung der Fehlerursache und etwaiger durch den Fehler herbeigeführter Folgeschäden durch ein Wartungsteam zu ermöglichen.

Im einfachsten, aber auch aufwendigsten, Fall findet eine Fehlerortung durch Inaugenscheinnahme statt. Dabei fährt das Wartungsteam die fehlerhafte Leitung ab und untersucht sie auf sichtbare Fehlerstellen. Diese Vorgehensweise ist langsam und fehleranfällig.

Daher ist man weitgehend dazu übergegangen, den Fehlerort, an dem sich der Fehler auf der Leitung befindet, mittels einer Analyse von während des Fehlereintritts erfassten Messgrößen, z.B. Strömen und Spannungen, einzugrenzen. Hierfür sind mittlerweile mehrere unterschiedliche Verfahren bekannt, deren Genauigkeit sich signifikant auf den Wartungsaufwand des Energieversorgungsnetzes auswirkt. Daher wird großer Wert darauf gelegt, die Genauigkeit der für die Fehlerortung eingesetzten Algorithmen zu verbessern, um die Wartung zu erleichtern und insbesondere fehlerbedingte Ausfallzeiten des Energieversorgungsnetzes zu verkürzen.

Ein grobes Ergebnis des Fehlerortes lässt sich beispielsweise durch die Feststellung der Fehlerrichtung erreichen. Diese Methode wird überwiegend in gelöschten, isolierten sowie hochohmig geerdeten Energieversorgungsnetzen mit einer radialen Struktur bzw. einem geringen Vermaschungsgrad eingesetzt. Dabei kann beispielsweise eine wattmetrische Methode verwendet werden, wie sie aus dem Europäischen Patent EP 2476002 B1 bekannt ist. Eine andere Methode zur Erkennung der Fehlerrichtung ist das sogenannte "Wischerrelais-Prinzip", das in einer möglichen Ausführungsform beispielsweise aus der internationalen Patentanmeldung WO 2012126526 A1 hervorgeht. Zur genaueren Fehlerortung ist bei diesen Methoden allerdings eine zusätzliche Auswertung nötig.

Verfahren zur genaueren Fehlerortung verwenden beispielsweise die gemessenen Strom- bzw. Spannungssignale der Grundwelle (50Hz- bzw. 60Hz-Signale) zur Fehlerortung. Hierbei sind Verfahren bekannt, die Messwerte von nur einem der Leitungsenden (einseitige Fehlerortung) oder Messwerte von beiden Leitungsenden (zweiseitige Fehlerortung) verwenden. Als Ergebnis wird der Fehlerort in der Regel als Entfernung von der jeweiligen Messstelle (in Prozent der Leitung oder in km bzw. Meilen) angegeben.

Im Fall der Verwendung von Messwerten nur eines Leitungsendes ist der Aufwand zur Durchführung der Fehlerortung gering. Bei dieser Fehlerortungsmethode handelt es sich überwiegend um eine impedanzbasierte Methode, bei der aus Strom- und Spannungsmesswerten eine Impedanz bis zum Fehlerort berechnet wird. Durch Vergleich mit der Leitungsimpedanz der gesamten Leitung im fehlerfreien Fall lässt sich ein Rückschluss auf den Fehlerort ziehen. Eine beispielhafte Ausführung eines solchen Fehlerortungsverfahrens kann beispielsweise der US-Patentschrift US 4,996,624 entnommen werden.

Die Genauigkeit dieser Methode hängt unter anderem stark von der Messgenauigkeit der verwendeten Strom- und Spannungswandler, der Genauigkeit der zur Fehlerortung verwendeten Leitungsparameter (z.B. Impedanzbelag) sowie von den gegebenen Fehlerbedingungen (z.B. Fehlerwiderstand, Last) und der Netzbeschaffenheit ab. Störungen und die Einschwingvorgänge in den Strom- und Spannungssignalen können sich negativ auf die Genauigkeit dieser Methode auswirken. Die dadurch entstehenden Messfehler können mehrere Prozent betragen.

Eine verbesserte Genauigkeit bei der Fehlerortung lässt sich durch die Verwendung von Messwerten von beiden Leitungsenden erreichen. Hierbei müssen die fehlerortungsbezogenen Messwerte über eine geeignete Kommunikationsverbindung zusammengeführt werden. In diesem Zusammenhang sei auf die US-Patentschrift US 5,929,642 verwiesen; bei dem dort beschriebenen Verfahren wird unter Verwendung von Strom- und Spannungsmesswerten von beiden Leitungsenden mithilfe von Schätzverfahren und nichtlinearen Optimierungsverfahren eine recht hohe Genauigkeit (Messfehler ca. 1-2%) bei der Fehlerortung erreicht.

Während die Genauigkeit der Fehlerortung bei den impedanzbasierten Fehlerortungsverfahren von der Messgenauigkeit der verwendeten Messwandler sowie der Netzbeschaffenheit abhängt, lässt sich durch die Verwendung eines Fehlerortungsverfahrens nach dem sogenannten Wanderwellen-Prinzip ("Traveling Wave Fault Location") eine weitgehende Unabhängigkeit von diesen Größen erreichen. Nach diesem Prinzip werden anstelle der Grundwellen der gemessenen Strom- und Spannungssignale die beim Fehler entstehenden transienten Signalanteile, die in Form von sogenannten "Wanderwellen" auftreten, zur Fehlerortung in Betracht gezogen. Hierbei werden die hochfrequenten Wanderwellen-Flanken messtechnisch erfasst und mit einem Zeitstempel versehen. Da die Propagationsgeschwindigkeit der Wanderwellen etwa bei der Lichtgeschwindigkeit liegt, lässt sich aus der Auswertung der Zeitstempelung die Ortung des Fehlers gut durchführen. Mit diesem Fehlerortungsverfahren können Genauigkeiten im Bereich von wenigen Dutzend Metern erreicht werden.

Ein Beispiel eines Fehlerortungsverfahrens der eingangs genannten Art kann der US-Patentanmeldung US 2006/0012374 A1 entnommen werden. Siehe auch US 2014/074414, US 2011/109465, US 2015/081235, CH 684 660, US 3 590 368 und US 4 183 072.

Eine Schwierigkeit bei der Fehlerortung nach dem Wanderwellenprinzip besteht in der Positionierung des für die Auswertung der Messwerte verwendeten Datenfensters, also der Auswahl einer geeigneten Zeitreihe von Messwerten, anhand derer die Ermittlung des Fehlerortes stattfinden kann. So muss bei einer beidseitigen Fehlerortung nach dem Wanderwellenprinzip das für die Fehlerortung verwendete Datenfenster exakt in dem Zeitbereichs platziert werden, in dem tatsächlich ein Fehler auf der Leitung vorliegt. Eine falsche Fensterpositionierung ist eine der wesentlichen Fehlerursachen, die zu einer ungenauen bzw. falschen Fehlerortung führen können.

Zur Positionierung des Datenfensters ist es bisher beispielsweise bekannt, die gemessenen Signale der Grundwelle, also die z.B. 50Hz- bzw. 60Hz-Signale, zu verwenden. Hierbei wird die Positionierung des Datenfensters in Abhängigkeit von einem Anregesignal einer Schutzfunktion gebildet. Dabei kann es sich z.B. um die Überschreitung eines Stromschwellenwertes handeln, der von einer Überstrom-Schutzfunktion festgestellt wird. Da Schutzfunktionen jedoch bisweilen zu empfindlich oder zu unempfindlich eingestellt sind, ist eine Datenfensterpositionierung auf Basis der Anregesignale unter Umständen mit Ungenauigkeiten verbunden.

Zur Reduktion der Ungenauigkeiten können weitere Algorithmen verwendet werden, die jedoch insbesondere im Falle einer weiteren Fehlerentwicklung (z.B. Folgefehler, Fehlerausweitung) oft versagen.

Da Schutzfunktionen außerdem mit Messwerten arbeiten, die mit vergleichsweise geringen Abtastraten aufgenommen worden sind, liegt der Beginn der von einer Schutzfunktion erkannten Anregung möglicherwiese erst deutlich nach dem tatsächlichen Zeitpunkt des Fehlereintritts, so dass ein auf dieser Grundlage positioniertes Datenfenster die für die Auswertung von Wanderwellen wesentliche Fehlereintrittsphase möglicherweise verpassen würde. Beispielsweise liegen nämlich typische Abtastraten für Schutzfunktionen, die die Grundwelle des Messsignals auswerten, bei wenigen Kilohertz liegen, z.B. zwischen etwa 1 kHz und 16 kHz, während die im Zusammenhang mit Wanderwellen verwendeten Abtastraten deutlich darüber, z.B. etwa bei 1 bis 10 MHz, liegen. Damit ist der mittels der Anregung der Schutzfunktion erkannte Beginn eines Datenfensters typischerweise um 7 bis 20ms gegenüber dem tatsächlichen Fehlereitritt verzögert. Da der zur Auswertung von Wanderwellen relevante Zeitbereich zwischen 0,1 und 10ms nach dem Fehlereintritt liegt, kann im schlimmsten Fall der relevante Zeitbereich bei Positionierung des Datenfensters anhand der Schutzfunktions-Anregung komplett außerhalb des verwendeten Datenfensters liegen.

Aus der US 2006/0012374 A1 ist es bekannt, anhand von Stromänderungen im Signal der Grundwelle auf einen vorhandenen Fehler zu schließen und auf dieser Basis das Datenfenster für die Auswertung von Wanderwellen zu positionieren.

Davon ausgehend liegt der Erfindung die Aufgabe zugrunde, die Positionierung eines Datenfensters für eine Fehlerortung nach dem Wanderwellenprinzip möglichst exakt auszuführen und damit die Genauigkeit der bei der Fehlerortung zu verbessern.

Diese Aufgabe wird erfindungsgemäß durch ein Verfahren der eingangs genannten Art gelöst, bei dem mit den an dem ersten Leitungsende gemessenen ersten Strom- und Spannungswerten geschätzte zweite Strom- oder Spannungswerte bestimmt werden, die den am zweiten Leitungsende fließenden Strom oder die am zweiten Leitungsende anliegende Spannung angeben, die geschätzten zweiten Strom- oder Spannungswerte mit den am zweiten Leitungsende gemessenen zweiten Strom- oder Spannungswerten verglichen werden, und zur Bestimmung eines ersten Fehlerortes solche erste und zweite Strom- und Spannungswerte herangezogen werden, die innerhalb einer durch ein erstes Datenfenster festgelegten Zeitdauer liegen, wobei der Beginn des ersten Datenfensters auf denjenigen Zeitpunkt festgesetzt wird, zu dem eine Abweichung zwischen den geschätzten zweiten Strom- oder Spannungswerten und den gemessenen zweiten Strom- oder Spannungswerten erkannt wird.

Bei dem erfindungsgemäßen Verfahren wird somit das Datenfenster in demjenigen Zeitbereich im zeitlichen Verlauf der Strom- und Spannungswerte positioniert, in dem ein Fehler auf der Leitung erkannt wird. Die Erkennung des Fehlers erfolgt bei Erkennung einer Abweichung zwischen den anhand der Messungen am ersten Leitungsende bestimmten geschätzten zweiten Spannungs- oder Stromwerten am anderen Leitungsende und den tatsächlich am anderen Leitungsende gemessenen Spannungs- oder Stromwerten. Diese stimmen im fehlerbehafteten Zustand nicht überein, so dass durch eine Erkennung des Vorliegens eines Fehlers der Beginn des Datenfensters festgelegt werden kann. Da die zur Erkennung des Fehlers herangezogenen Messsignale mit einer für die Wanderwellenauswertung geeigneten hohen Abtastrate abgetastet werden, kann die Festlegung des Beginns des Datenfensters auch mit sehr hoher Genauigkeit erfolgen. Anstelle nämlich wie bisher üblich Anregesignale der Schutzfunktionen (z.B. Strom überschreitet einen Schwellenwert) für eine Positionierung des Datenfensters heranzuziehen, werden vorliegend aus den für die Fehlerortung nach dem Wanderwellenprinzip aufgenommenen Strom- oder Spannungswerten vom ersten Leitungsende die geschätzten Strom- oder Spannungswerte am zweiten Leitungsende bestimmt. Der Zeitraum, in denen sich die geschätzten von den gemessenen zweiten Strom- bzw. Spannungswerten unterscheiden, entspricht dem Zeitraum, in dem die Leitung fehlerbehaftet ist. Durch diese genaue Erkennung des Zeitraums des Fehlers auf der Leitung kann eine sehr exakte Positionierung des für die Auswertung herangezogenen Datenfensters erfolgen, indem der Beginn des Datenfensters in Abhängigkeit von demjenigen Zeitpunkt festgelegt wird, zu dem eine Abweichung zwischen den geschätzten und den gemessenen Werten erkannt wird. Dabei kann der Beginn des Datenfensters exakt festgelegt werden. Er kann aber auch etwas früher festgelegt werden, um eine gewisse Sicherheit bei der Erfassung der durch den Fehler hervorgerufenen Wanderwellen-Phänomene zu erreichen.

Die zur Zeitstempelung der Strom- und/oder Spannungsmesswerte an beiden Leitungsenden verwendeten Zeitgeber (z.B. interne Uhren von Messeinrichtungen) werden bei dem erfindungsgemäßen Verfahren zeitlich miteinander synchronisiert, so dass die an beiden Leitungsenden vergebenen Zeitstempel miteinander vergleichbar sind.

Eine vorteilhafte Ausführungsform des erfindungsgemäßen Verfahrens sieht vor, dass zum Erkennen einer Abweichung zwischen den geschätzten zweiten Strom- oder Spannungswerten und den gemessenen zweiten Strom-oder Spannungswerten die Differenz aus den geschätzten zweiten Strom- oder Spannungswerten und den gemessenen zweiten Strom- oder Spannungswerten gebildet wird, und eine Abweichung dann erkannt wird, wenn der Betrag der Differenz einen ersten Schwellenwert überschreitet, wobei der erste Schwellenwert in Abhängigkeit von der Höhe des am ersten Leitungsende fließenden Stroms gewählt wird.

Auf diese Weise kann durch einfache mathematische Operationen, nämlich eine Differenzbildung und ein Vergleich mit einem Schwellenwert, eine Abweichung zwischen den geschätzten und den gemessenen zweiten Strom-oder Spannungswerten erkannt werden. Dadurch dass der Schwellenwert in Abhängigkeit von der Höhe des am ersten Leitungsende fließenden Stroms gebildet wird, kann die Empfindlichkeit bei der Erkennung einer Abweichung auf die jeweilige Betriebssituation, insbesondere die Lastsituation der Leitung, angepasst werden.

Eine weitere vorteilhafte Ausführungsform des erfindungsgemäßen Verfahrens sieht vor, dass zur Bestimmung der geschätzten zweiten Strom- oder Spannungswerte ein mathematisches Modell der Leitung für den fehlerfreien Fall herangezogen wird.

Auf diese Weise kann bei Kenntnis von Leitungsparametern der fehlerfreien Leitung, wie z.B. eine Ausbreitungskontante bzgl. der Ausbreitung von Wanderwellen entlang der Leitung und eine Wellenimpedanz, unter Verwendung eines für die Ausbreitung von Wanderwellen gültigen mathematischen Leitungsmodells eine Bestimmung der Strom- oder Spannungswerte am anderen Leitungsende vorgenommen werden. Die berechneten Werte stimmen für den fehlerfreien Fall mit den am anderen Leitungsende gemessenen Werten überein.

Konkret kann in diesem Zusammenhang vorgesehen sein, dass zur Bestimmung der geschätzten zweiten Strom- oder Spannungswerte die ersten Strom- und Spannungswerte einer Filterung unterzogen werden, wobei mit dem Filter eine zumindest von der Ausbreitungskonstante einer Wanderwelle entlang der Leitung abhängige Übertragungsfunktion nachgebildet wird.

Hierdurch lassen sich mit vergleichsweise niedrigem Rechenaufwand durch geeignete Filterung der ersten Strom- und Spannungswerte die gesuchten geschätzten zweiten Strom- oder Spannungswerte ermitteln, indem die Ausbreitungskonstante auf der Leitung berücksichtigt wird. Als Filter wird vorzugsweise ein digitaler FIR-Filter (FIR = Finite Impulse Response) eingesetzt.

Außerdem kann in diesem Zusammenhang zusätzlich vorgesehen sein, dass bei der Filterung der ersten Spannungswerte zusätzlich ein Filter verwendet wird, mit dem eine von der Wellenimpedanz der Leitung abhängige Übertragungsfunktion nachgebildet wird.

Hierdurch lassen sich mit vergleichsweise niedrigem Rechenaufwand durch geeignete Filterung der ersten Strom- und Spannungswerte die gesuchten geschätzten zweiten Strom- oder Spannungswerte ermitteln, indem die Wellenimpedanz der Leitung berücksichtigt wird. Als Filter wird vorzugsweise ein digitaler IIR-Filter (IIR = Infinite Impulse Response) eingesetzt.

Gemäß einer Ausführungsform des erfindungsgemäßen Verfahrens kann vorgesehen sein, es sich bei den für die Ermittlung des ersten Fehlerortes herangezogenen Strom- und Spannungswerten um abgespeicherte Strom- und Spannungswerte handelt.

Bei dieser Variante findet eine sogenannte "Offline-Fehlerortung" anhand von abgespeicherten Strom- und Spannungswerten statt, um den Fehlerort nach dem Fehler ermitteln zu können. Da üblicherweise für die Ortung des Fehlers mehr Zeit zur Verfügung steht als für dessen Erkennung und Abschaltung, stellt der bei Verwendung einer Offline-Methode entstehende Zeitversatz zwischen Eintritt des Fehlers und Fehlerortung normalerweise kein Problem dar.

Alternativ kann aber auch vorgesehen sein, dass es sich bei den für die Ermittlung des ersten Fehlerortes herangezogenen Strom- und Spannungswerten unmittelbar um jeweils aktuell gemessene Strom- und Spannungswerte handelt.

Diese Variante stellt eine sogenannte "Online-Fehlerortung" dar, bei der unmittelbar nach Erfassung der für die Fehlerortung relevanten Strom- und Spannungswerte und nach Positionierung des zur Fehlerortermittlung heranzuziehenden Datenfensters die Fehlerortung stattfindet. Der Fehlerort lässt sich auf diese Weise somit schneller als bei der Offline-Methode ermitteln.

Gemäß einer weiteren vorteilhaften Ausführungsform des erfindungsgemäßen Verfahrens kann vorgesehen sein, dass ein Datenfenster mit einer festgelegten Länge verwendet wird.

Bei dieser Ausführungsform kann durch eine einfache Parametereinstellung die Länge des Datenfensters, also die von dem Datenfenster abgedeckte Zeitdauer der auszuwertenden zeitlichen Verläufe, definiert werden. Die Länge ist dabei so zu wählen, dass alle auszuwertenden Wanderwellen in dem Datenfenster liegen. Erfahrungsgemäß ist dies nach einer Zeitdauer der Fall, die sich aus dem Quotienten der vierfachen Leitungslänge und der Wellengeschwindigkeit ergibt (Beispiel für eine Leitung von 100km Länge: $t = 4 \times 100km / 0,98c = 1,4$ ms; $c$ = Lichtgeschwindigkeitskonstante).

Gemäß einer anderen Alternative des erfindungsgemäßen Verfahrens kann auch vorgesehen sein, dass ein Datenfenster mit einer variablen Länge verwendet wird, wobei das Ende des Datenfensters in Abhängigkeit von demjenigen Zeitpunkt festgelegt wird, zu dem zu dem keine Abweichung mehr zwischen den geschätzten zweiten Strom- oder Spannungswerten und den gemessenen zweiten Strom- oder Spannungswerten erkannt wird.

Gemäß dieser Ausführungsform kann anhand des auch zur Positionierung des Datenfensters verwendeten Algorithmus eine Erkennung der Dauer des Fehlerzustands auf der Leitung durchgeführt werden. Das Ende des Datenfensters kann dann entweder auf den Zeitpunkt des Fehlerendes oder einen etwas später liegenden Zeitpunkt festgelegt werden. Bei dieser Ausführungsform kann die Länge des Datenfensters somit sehr flexibel an die tatsächliche Dauer des Fehlerzustands angepasst werden.

Gemäß einer weiteren vorteilhaften Ausführungsform des erfindungsgemäßen Verfahrens kann zudem vorgesehen sein, dass mit den an dem zweiten Leitungsende gemessenen zweiten Strom- und Spannungswerten geschätzte erste Strom- oder Spannungswerte berechnet werden, die den am ersten Leitungsende fließenden Strom oder die am ersten Leitungsende anliegende Spannung angeben, die geschätzten ersten Strom- oder Spannungswerte mit den am ersten Leitungsende gemessenen ersten Strom- oder Spannungswerten verglichen werden, und zur Bestimmung eines zweiten Fehlerortes solche erste und zweite Strom- und Spannungswerte herangezogen werden, die innerhalb einer durch ein zweites Datenfenster festgelegten Zeitdauer liegen, wobei der Beginn des zweiten Datenfensters auf denjenigen Zeitpunkt festgesetzt wird, zu dem eine Abweichung zwischen den geschätzten ersten Strom- oder Spannungswerten und den gemessenen ersten Strom- oder Spannungswerten erkannt wird.

Bei dieser Ausführungsform finden die Fehlerortung und die dazu benötigte Positionierung des Datenfensters nicht nur an einem Leitungsende, sondern an beiden Leitungsenden in entsprechender Weise statt. Sämtliche zuvor zum einseitigen Verfahren beschriebenen Merkmale, Vorteile und Ausführungsformen sind in entsprechender Weise auch auf das beidseitige Verfahren anwendbar bzw. übertragbar.

Bei der letztgenannten Ausführungsform wird die Fehlerortermittlung beispielsweise in einer zentralen Einrichtung durchgeführt. Sie kann aber auch in Einrichtungen an beiden Leitungsenden, zwar auf Basis derselben Messwerte, aber dennoch unabhängig voneinander, vorgenommen werden, weshalb auch zwei Ergebnisse der Fehlerortermittlung (erster und zweiter Fehlerort) erzeugt werden. Es ist hierbei möglich, dass in den Einrichtungen zur Fehlerortung in Teilen unterschiedliche Algorithmen ausgeführt werden. Anhand der Übereinstimmung der Ergebnisse von beiden Leitungsenden kann auf die Zuverlässigkeit des Ergebnisses geschlossen werden.

Der am jeweiligen Leitungsende ermittelte Fehlerort kann z.B. in Prozent der Leitungslänge oder als Entfernung von der jeweiligen Messstelle (z.B. in km oder Meilen) direkt an der Einrichtung angezeigt werden oder in Form eines Signals oder Datentelegramms ausgegeben und an einen Betreiber des Energieversorgungsnetzes übermittelt werden. Bei den Einrichtungen an den beiden Leitungsenden kann es sich beispielsweise um - meist ohnehin vorhandene - Schutzgeräte zur Überwachung der Leitung auf Fehler handeln.

In diesem Zusammenhang kann konkret vorgesehen sein, dass der Fehlerort des auf der Leitung aufgetretenen Fehlers unter Verwendung des ersten Fehlerortes und des zweiten Fehlerortes bestimmt wird.

Im Idealfall wird zwar der erste Fehlerort mit dem zweiten Fehlerort übereinstimmen, allerdings kann es in der Realität z.B. durch Messungenauigkeiten, Wandlerfehler und andere Einflüsse vorkommen, dass an beiden Enden unterschiedliche Ergebnisse bei der Fehlerortung bestimmt werden. Der endgültige Fehlerort kann dann entweder als Alternative angegeben werden ("Fehler liegt bei Fehlerort 1 oder Fehlerort 2 vor") oder durch geeignete Verknüpfung des ersten und des zweiten Fehlerortes ermittelt werden. Wenn der Fehlerort beispielweise mit einem gewissen Werteraum angegeben wird (z.B. einer auf die Messung angepassten Fehlertoleranz), könnte der zu verwendende Fehlerort als derjenige Ort (oder Bereich) angegeben werden, an dem sich die Wertebereiche des ersten und des zweiten Fehlerortes überschneiden.

Gemäß einer anderen Alternative kann auch vorgesehen sein, dass der Fehlerort des auf der Leitung aufgetretenen Fehlers durch Mittelwertbildung aus dem ersten Fehlerort und dem zweiten Fehlerort gebildet wird.

Die oben genannte Aufgabe wird auch durch eine Einrichtung zum Ermitteln des Fehlerortes eines Fehlers auf einer Leitung eines elektrischen Energieversorgungsnetzes gelöst. Die Einrichtung weist eine Recheneinrichtung auf, die dazu eingerichtet ist, unter Verwendung von an einem ersten Leitungsende der Leitung gemessenen und zeitgestempelten ersten Strom- und Spannungswerten und an einem zweiten Leitungsende der Leitung gemessenen und zeitgestempelten zweiten Strom- und Spannungswerten nach dem Auftreten eines Fehlers auf der Leitung dessen Fehlerort zu bestimmen.

Erfindungsgemäß ist vorgesehen, dass die Recheneinrichtung dazu eingerichtet ist, mit den an dem ersten Leitungsende gemessenen ersten Strom- und Spannungswerten geschätzte zweite Strom- oder Spannungswerte zu bestimmen, die den am zweiten Leitungsende fließenden Strom oder die am zweiten Leitungsende anliegende Spannung angeben, dass die Recheneinrichtung zudem dazu eingerichtet ist, die geschätzten zweiten Strom- oder Spannungswerte mit den am zweiten Leitungsende gemessenen zweiten Strom- oder Spannungswerten zu vergleichen, und dass die Recheneinrichtung ferner dazu eingerichtet ist, zur Bestimmung eines ersten Fehlerortes solche erste und zweite Strom- und Spannungswerte heranzuziehen, die innerhalb einer durch ein erstes Datenfenster festgelegten Zeitdauer liegen, wobei der Beginn des ersten Datenfensters auf denjenigen Zeitpunkt festgesetzt wird, zu dem eine Abweichung zwischen den geschätzten zweiten Strom- oder Spannungswerten und den gemessenen zweiten Strom- oder Spannungswerten erkannt wird.

Hinsichtlich der erfindungsgemäßen Einrichtung gelten alle zu dem erfindungsgemäßen Verfahren voranstehend und nachfolgend gemachten Ausführungen und umgekehrt in entsprechender Weise, insbesondere ist die erfindungsgemäße Einrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Einrichtung wird auf die zu dem erfindungsgemäßen Verfahren beschriebenen Vorteile verwiesen.

Konkret kann hinsichtlich der Einrichtung vorgesehen sein, dass die Einrichtung ein elektrisches Schutzgerät oder Teil eines elektrischen Schutzgerätes ist.

Alternativ kann aber auch vorgesehen sein, dass die Einrichtung ein Datenkonzentrator einer Schaltanlage des elektrischen Energieversorgungsnetzes ist.

Als Datenkonzentrator wird eine in der Schaltanlage angeordnete Einrichtung angesehen, die Daten von einem oder mehreren Schutz-, Mess- oder Leiteinrichtungen der Schaltanlage und/oder eine anderen Schaltanlage zusammenfasst. Der Datenkonzentrator kann dabei dazu eingerichtet sein, die zusammengefassten Daten, z.B. Messwerte und/oder Statusmeldungen, einer Vorverarbeitung und ggf. Datenreduktion zu unterziehen und an eine übergeordnete Einrichtung, z.B. eine Netzleitstelle, weiterzuleiten. Darüber hinaus kann der Datenkonzentrator auch dazu eingerichtet sein, mit den zusammengefassten Daten bestimmte Auswertungen, z.B. die oben beschriebene Fehlerortung, durchzuführen.

Die oben genannte Aufgabe wird schließlich auch durch ein System zum Ermitteln des Fehlerortes eines Fehlers auf einer Leitung eines elektrischen Energieversorgungsnetzes gelöst. Das System weist dabei eine nach einem der Ansprüche 12 bis 14 ausgebildete Einrichtung auf.

Erfindungsgemäß ist eine zweite Einrichtung vorgesehen, die eine Recheneinrichtung aufweist, wobei die Recheneinrichtung der zweiten Einrichtung dazu eingerichtet ist, mit den an dem zweiten Leitungsende gemessenen zweiten Strom- und Spannungswerten geschätzte erste Strom- oder Spannungswerte zu bestimmen, die den am ersten Leitungsende fließenden Strom oder die am ersten Leitungsende anliegende Spannung angeben, wobei die Recheneinrichtung der zweiten Einrichtung auch dazu eingerichtet ist, die geschätzten ersten Strom- oder Spannungswerte mit den am ersten Leitungsende gemessenen ersten Strom- oder Spannungswerten zu vergleichen, wobei die Recheneinrichtung der zweiten Einrichtung zudem dazu eingerichtet ist, zur Bestimmung eines zweiten Fehlerortes solche erste und zweite Strom- und Spannungswerte heranzuziehen, die innerhalb einer durch ein zweites Datenfenster festgelegten Zeitdauer liegen, wobei der Beginn des zweiten Datenfensters auf denjenigen Zeitpunkt festgesetzt wird, zu dem eine Abweichung zwischen den geschätzten ersten Strom- oder Spannungswerten und den gemessenen ersten Strom- oder Spannungswerten erkannt wird, und wobei die Recheneinrichtung der ersten Einrichtung und/oder die Recheneinrichtung der zweiten Einrichtung schließlich dazu eingerichtet ist, den Fehlerort unter Verwendung des ersten Fehlerortes und des zweiten Fehlerortes zu bestimmen.

Hinsichtlich des erfindungsgemäßen Systems gelten alle zu dem erfindungsgemäßen Verfahren und der erfindungsgemäßen Einrichtung voranstehend und nachfolgend gemachten Ausführungen und umgekehrt in entsprechender Weise, insbesondere ist das erfindungsgemäße System zur Durchführung des erfindungsgemäßen Verfahrens in jeder beliebigen Ausführungsform oder einer Kombination beliebiger Ausführungsformen eingerichtet. Auch hinsichtlich der Vorteile des erfindungsgemäßen Systems wird auf die zu dem erfindungsgemäßen Verfahren und der erfindungsgemäßen Einrichtung beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Es zeigen

Figur 1      eine schematische Ansicht einer Leitung eines Energieversorgungsnetzes mit einem ersten Ausführungsbeispiel eines Systems zur Ermittlung eines Fehlerortes;

Figur 2      eine schematische Ansicht einer Leitung eines Energieversorgungsnetzes mit einem zweiten Ausführungsbeispiel eines Systems zur Ermittlung eines Fehlerortes;

Figur 3      eine Darstellung der elektrischen Parameter eines Leitungsabschnitts $\Delta x$ zur Erläuterung der Bestimmung eines Fehlerortes nach dem Wanderwellenprinzip;

Figur 4      eine schematische Ansicht eines Ablaufdiagramms zur Erläuterung eines Ausführungsbeispiels eines Verfahrens zur Fehlerortung;

Figur 5      beispielhafte Verläufe von Strom- und Spannungswerten während eines Fehlers auf einer Leitung;

Figur 6      beispielhafte Verläufe von transformierten Strom- und Spannungswerten während eines Fehlers auf einer Leitung;

Figur 7      eine schematische Ansicht eines Blockschaltbilds zur Erläuterung der Positionierung eines Datenfensters;

Figur 8      eine schematische Ansicht eines Blockschaltbilds zur beispielhaften Erläuterung der Filterung von Spannungswerten;

Figur 9      ein beispielhaftes Diagramm mit den Verläufen von geschätzten zweiten Stromwerten und gemessenen zweiten Stromwerten;

Figur 10      ein erstes Beispiel der Ermittlung eines Fehlerortes aus einem ersten und einem zweiten Fehlerort; und

Figur 11      ein zweites Beispiel der Ermittlung eines Fehlerortes aus einem ersten und einem zweiten Fehlerort.

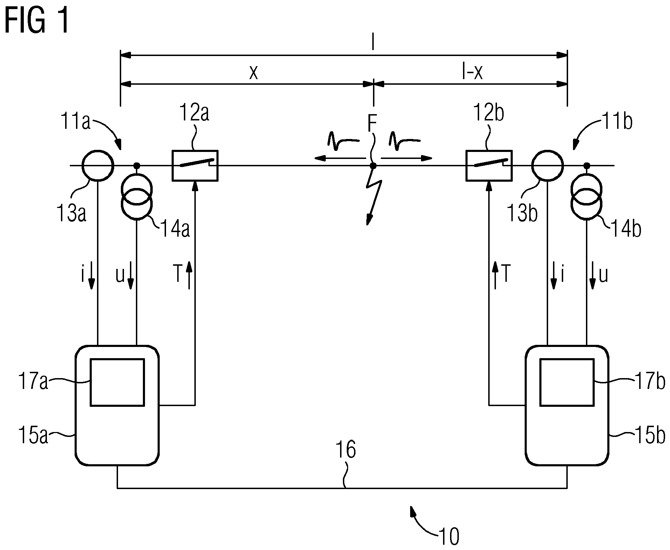

Figur 1 zeigt eine schematische Ansicht eines Systems 10 zum Ermitteln eines Fehlerortes in einem elektrischen Energieversorgungsnetz. Hierzu ist in Figur 1 eine elektrische Leitung 11 des Energieversorgungsnetzes in vereinfachter Darstellung gezeigt. Die Leitung habe die Länge l. Bei der Leitung 11 kann es sich um eine ein- oder eine mehrphasige Leitung handeln.

Die Leitung 11 wird an ihren Leitungsenden 11a und 11b durch Leistungsschalter 12a, 12b begrenzt und kann durch diese, insbesondere im Fehlerfall, vom restlichen, in Figur 1 nicht näher dargestellten, Energieversorgungsnetz abgetrennt werden. An den Leitungsenden 11a, 11b sind zudem Messstellen vorgesehen, an denen mit in Figur 1 lediglich beispielhaft dargestellten Stromwandlern 13a, 13b und Spannungswandlern 14a, 14b Strom- und Spannungsmesswerte erfasst werden. Bei den Stromwandlern 13a, 13b und den Spannungswandlern 14a, 14b kann es sich um sogenannte konventionelle oder nicht konventionelle Wandler handeln. Sekundärseitig werden von den Wandlern Strommesswerte i und Spannungsmesswerte u abgegeben, bei denen es sich um analoge oder digitalisierte Werte handeln kann.

Mit den Stromwandlern 13a, 13b und den Spannungswandlern 14a, 14b stehen an den jeweiligen Leitungsenden 11a, 11b Einrichtungen 15a, 15b zur Ermittlung eines Fehlerortes in Verbindung. Die Einrichtungen 15a, 15b erfassen die Strom- und Spannungsmesswerte und führen ggf. eine Digitalisierung und/oder eine Vorverarbeitung durch. Dabei wird den jeweiligen Messwerten auch ein Zeitstempel zugeordnet, der den Zeitpunkt ihrer Erfassung genau angibt. Zu diesem Zweck weisen die Einrichtungen 15a, 15b interne Zeitgeber auf, die untereinander mittels gängiger Verfahren, z.B. GPS-Zeitimpulsen, IRIG-B, IEEE 1588, zeitlich synchronisiert sind. Aufgrund der Zeitstempelung sind die an beiden Leitungsenden 11a, 11b aufgenommenen Messwerte miteinander vergleichbar.

Bei den Einrichtungen 15a, 15b kann es sich beispielsweise um elektrische Schutzgeräte handeln, die neben einer Fehlerortungsfunktion auch weitere Schutz- und Überwachungsfunktionen durchführen. Beispielsweise kann es sich bei den Schutzgeräten um Distanzschutzgeräte, Differentialschutzgeräte oder Überstromschutzgeräte handeln, die den Betriebszustand der Leitung 11 anhand der erfassten Strom- und Spannungsmesswerte überwachen und im Fehlerfall ein Ausschaltsignal T an ihren jeweiligen Leistungsschalter 12a, 12b übermitteln, um diesen zum Öffnen seiner Schaltkontakte zu veranlassen.

Die Einrichtungen 15a, 15b umfassen je eine Recheneinrichtung 17a, 17b, die jeweils dazu eingerichtet ist, im Fehlerfall auf der Leitung 11 den Fehlerort, also denjenigen Ort auf der Leitung, an dem ein Fehler (z.B. Kurzschluss, Erdschluss) aufgetreten ist, zu ermitteln und auszugeben. Hierzu werden die Strom- und Spannungsmesswerte des eigenen Leitungsendes und des jeweils anderen Leitungsendes, die während des Fehlers erfasst worden sind, verwendet. Zu diesem Zweck sind die Einrichtungen 15a, 15b über eine Kommunikationsverbindung 16, bei der es sich um eine beliebige geeignete drahtgebundene oder drahtlose Kommunikationsverbindung handeln kann, verbunden. Über die Kommunikationsverbindung 16 können die Einrichtungen 15a, 15b unter anderem ihre Strom- und Spannungsmesswerte zur Ermittlung des Fehlerortes austauschen.

Die Einrichtungen 15a, 15b führen eine Fehlerortung nach dem sogenannten Wanderwellenprinzip aus. Dabei wird ausgenutzt, dass beim Auftreten eines Fehlers hochfrequente transiente Signalanteile im Strom und in der Spannung entstehen, die sich etwa mit Lichtgeschwindigkeit auf der Leitung 11 in beiden Richtungen ausbreiten. Dies ist in Figur 1 beispielhaft eingezeichnet. Hierzu wird angenommen, dass an einem Fehlerort F ein Fehler aufgetreten sei. Die Wanderwellen breiten sich wie dargestellt von dem Fehlerort F sowohl in Richtung des ersten Leitungsendes 11a als auch in Richtung des zweiten Leitungsendes 11b aus und können dort mit den Wandlern messtechnisch erfasst und mit den Einrichtungen 15a, 15b zur Fehlerortbestimmung ausgewertet werden. Von dem ersten Leitungsende aus gesehen liegt der Fehlerort F in einer Entfernung x, entsprechend liegt der Fehlerort F aus Sicht des zweiten Leitungsendes in einer Entfernung l-x. Die Einrichtungen werten wie nachfolgend im Einzelnen beschrieben die Strom- und Spannungsmesswerte aus und geben den Fehlerort F, beispielsweise als Entfernung oder Prozent der Leitungslänge l an.

Der Betreiber des Energieversorgungsnetzes kann den ermittelten Fehlerort F an ein Wartungsteam weitergeben, das daraufhin den Fehlerort aufsuchen und die Fehlerursache beheben kann. Hierzu ist eine möglichst genaue Ermittlung des Fehlerortes erforderlich.

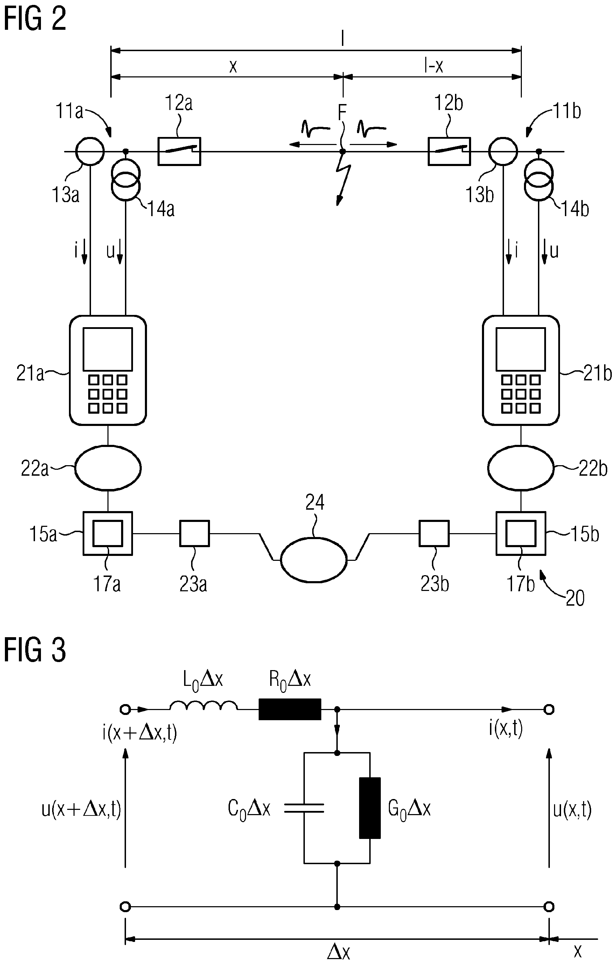

In einem anderen Ausführungsbeispiel eines Systems 20 zur Fehlerortung, das schematisch in Figur 2 gezeigt ist, kann es sich bei den Einrichtungen 15a, 15b auch um Datenkonzentratoren handeln. Im Ausführungsbeispiel nach Figur 2 werden wie zu Figur 1 beschrieben Messwerte von Strom- und Spannung über entsprechende Wandler 13a, 13b, 14a, 14b mittels Messgeräten 21a, 21b aufgenommen. Bei den Messgeräten 21a, 21b kann es sich z.B. um Schutzgeräte der zu Figur 1 beschriebenen Art handeln. In einem anderen Fall kann es sich bei den Messgeräten 21a, 21b um sogenannte Störschreiber handeln, die ereignisgesteuert oder kontinuierlich Messwerte mit hoher Abtastrate aufnehmen und abspeichern.

Beispielsweise kann vorgesehen sein, dass die Messgeräte 21a, 21b ereignisgesteuert Störschriebe, also eine Zeitreihe von Strom- und Spannungswerten während eines angenommenen Fehlerzustands, aufnehmen. Aufgrund der möglichen Überfunktion der hierfür eingesetzten Triggerverfahren muss ein aufgezeichneter Störschrieb nicht notwendigerweise einen Fehler auf der zu überwachenden Leitung 11 enthalten. Ein aufgezeichneter Störschrieb wird nach Aufzeichnung an den im lokalen Netzwerk 22a, 22b der jeweiligen Schaltanlage befindlichen Datenkonzentrator 15a, 15b übertragen.

Die Datenkonzentratoren 15a, 15b der Schaltanlagen an beiden Leitungsenden sind, z.B. mittels Kommunikationsgeräten 23a, 23b (z.B. Routern), mit einem Weitbereichs-Netzwerk 24 (Wide Area Network - WAN) verbunden. Der jeweilige Datenkonzentrator 15a, 15b überträgt den vom Messgerät 21a, 21b empfangenen Störschrieb über das Weitbereichsnetzwerk 24 an den Datenkonzentrator 15b, 15a am jeweils anderen Leitungsende. Als Ergebnis liegen in den Datenkonzentratoren 15a, 15b die Störschriebe von beiden Leitungsenden vor. Diese Störschriebe werden danach zur Durchführung einer Fehlerortung herangezogen.

Während das System 10 nach Figur 1 sowohl für eine Online-Fehlerortung auf Basis unmittelbar erfasster Messwerte als auch für eine Offline-Fehlerortung auf Basis abgespeicherter Messwerte geeignet ist, eignet sich das System 20 der Figur 2 eher für eine Offline-Fehlerortung, da mehrere Speicher- und Übertragungsschritte durchgeführt werden. Bei entsprechend schneller Übertragung und Datenauswertung kann das System 20 aber auch zur Online-Fehlerortung herangezogen werden, bei der unmittelbar nach dem Fehler auch dessen Fehlerort angezeigt wird.

Nachfolgend wird eine Vorgehensweise zur genauen Fehlerortung beschrieben. Zunächst soll eine kurze Erläuterung des Prinzips der Wanderwellen-Fehlerortung gegeben werden. Hierzu wird nachfolgend ein zweiseitiger Wanderwellen-Fehlerorter-Algorithmus erläutert, also ein Algorithmus, der mit Messwerten von beiden Leitungsenden 11a, 11b arbeitet. Dabei wird ein Ausbreitungsmodell für Wanderwellen entlang der Leitung 11 verwendet.

Zur Aufstellung des fraglichen Algorithmus wird die "Theorie der Langen Leitungen" eingesetzt. Es handelt sich hierbei um die modellhafte Abbildung einer elektrischen Leitung in Form von sogenannten "verteilten Parametern". Dies ist beispielhaft in Figur 3 dargestellt.

Der Figur 3 ist zu entnehmen, dass die Netzparameter wie Induktivitätsbelag $L_0$, Kapazitätsbelag $C_0$, Widerstandsbelag $R_0$ sowie Konduktivitätsbelag $G_0$ längs der Leitung verteilt sind. Basierend auf diesem Leitungsmodell können unter Verwendung von Kirchhoffschen-Gesetzen für das Teilstück $\Delta x$ der Leitung folgende Gleichungen für die Spannung u und den Strom i aufstellt werden:

$$u(x+\Delta x,t) = R_0\Delta x \cdot i(x+\Delta x,t) + L_0\Delta x \frac{\partial i(x+\Delta x,t)}{\partial t} + u(x,t) \qquad (1)$$

$$i(x + \Delta x, t) = G_0 \Delta x \cdot u(x,t) + C_0 \Delta x \frac{\partial u(x,t)}{\partial t} + i(x,t) \qquad (2)$$

Durch mathematische Umformungen lassen sich die Gleichungen (1) und (2) in die folgende Form überführen:

$$\frac{\partial u(x,t)}{\partial x} = R_0 \cdot i(x,t) + L_0 \frac{\partial i(x,t)}{\partial t} \qquad (3)$$

$$\frac{\partial i(x,t)}{\partial x} = G_0 \cdot u(x,t) + C_0 \frac{\partial u(x,t)}{\partial t} \qquad (4)$$

Diese Gleichungen (3) und (4) sind partielle Differentialgleichungen einer homogenen Leitung und werden üblicherweise als "Telegraphengleichungen" bezeichnet. Sie lassen sich auf beliebige Anzahlen von Leitern verallgemeinern.

Durch die Betrachtung der Gleichungen (3) und (4) im Laplace-Bereich unter der Annahme von x als Parameter lassen sich viele in der Leitung entstehende Effekte wesentlich einfacher interpretieren:

$$\frac{\partial u(x,s)}{\partial x} = R_0 \cdot i(x,s) + sL_0 \cdot i(x,s) \qquad (5)$$

$$\frac{\partial i(x,s)}{\partial x} = G_0 \cdot u(x,s) + sC_0 \cdot u(x,s) \qquad (6)$$

Die Ableitung der Gleichungen (5) und (6) nach Parameter x ergibt:

$$\frac{\partial^2 u(x,s)}{\partial x^2} = Z(s)Y(s) \cdot u(x,s) \qquad (7)$$

$$\frac{\partial^2 i(x,s)}{\partial x^2} = Y(s)Z(s) \cdot i(x,s) \qquad (8)$$

Gleichungen (7) und (8) lassen sich unter Verwendung der Differentialgleichungstheorie für Spannung und Strom separat lösen:

$$U(x) = e^{-\gamma(s)x} \cdot A_1 + e^{\gamma(s)x} \cdot A_2 \qquad (9)$$

$$Z_c(s) \cdot I(x) = e^{-\gamma(s)x} \cdot A_1 - e^{\gamma(s)x} \cdot A_2 \qquad (10)$$

Bei der Lösung der Gleichungen (9) und (10) ist es möglich, die unbekannten Parameter $A_1$ und $A_2$ von den Anfangsbedingungen auszurechnen:

$$A_1 = \frac{1}{2}\left(U_1(s) + Z_c(s) \cdot I_1(s)\right) \qquad (11)$$

$$A_2 = \frac{1}{2}\left(U_1(s) - Z_c(s) \cdot I_1(s)\right) \qquad (12)$$

wobei $U_1$ und $I_1$ die Anfangsbedingungen bei x=0 darstellen.

Darüber hinaus beinhalten Gleichungen (9) und (10) eine sogenannte Wellenimpedanz $Z_c$ und die Ausbreitungskonstante $\gamma$, die sich aus den Leitungsparametern berechnen lassen:

$$\gamma(s)^2 = Z(s)Y(s) \qquad (13)$$

$$Z_c(s) = \gamma(s)^{-1} \cdot Z(s) \qquad (14)$$

Hierbei steht Z für die Längsimpedanz und Y für die Queradmittanz eines Abschnitts der Leitung. Die Werte werden jeweils längenbezogen angegeben.

Somit ergeben sich für die Gleichungen (9) und (10) folgende Formen:

$$U(x,s) = \frac{1}{2}e^{-\gamma(s)x} \cdot \left(U_1(s) + Z_c(s) \cdot I_1(s)\right) + \frac{1}{2}e^{\gamma(s)x} \cdot \left(U_1(s) - Z_c(s) \cdot I_1(s)\right) \qquad (15)$$

$$Z_c(s) \cdot I(x,s) = \frac{1}{2}e^{-\gamma(s)x} \cdot \left(U_1(s) + Z_c(s) \cdot I_1(s)\right) - \frac{1}{2}e^{\gamma(s)x} \cdot \left(U_1(s) - Z_c(s) \cdot I_1(s)\right) \qquad (16)$$

Gleichungen (15) und (16) stellen ein spannungs- bzw. strombezogenes Ausbreitungsmodell für Wanderwellen entlang der Leitung 11 dar, das zur Fehlerortung nach der Wanderwellenmethode eingesetzt werden kann.

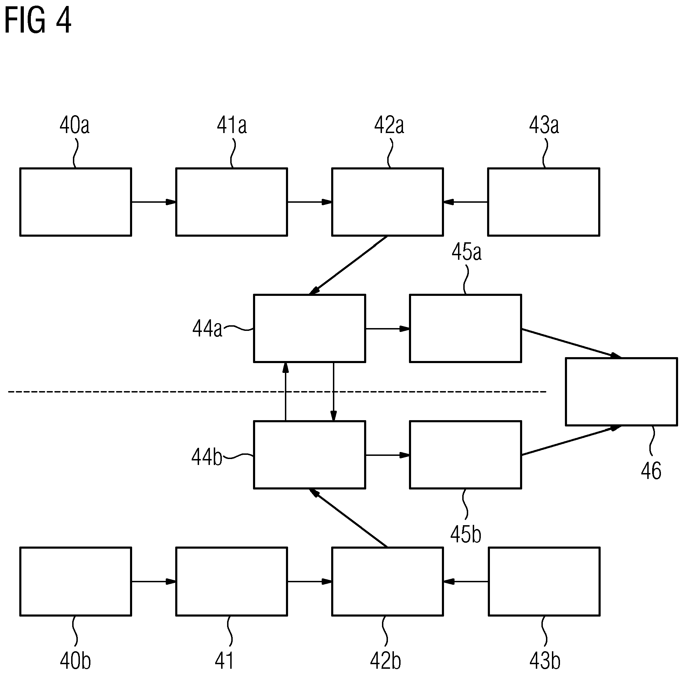

Anhand von Figur 4 soll an einem möglichen Beispiel die Vorgehensweise zur Fehlerortung nach dem Wanderwellenprinzip erläutert werden. Figur 4 zeigt hierzu ein schematisches Ablaufdiagramm eines Ausführungsbeispiels eines Verfahrens zur Ermittlung eines Fehlerortes. Dabei finden die Verfahrensschritte oberhalb der gestrichelten Linie in der Einrichtung 15a am ersten Leitungsende 11a, diejenigen unterhalb der gestrichelten Linie in der Einrichtung 15b am zweiten Leitungsende 11b (vgl. Figuren 1 und 2) statt.

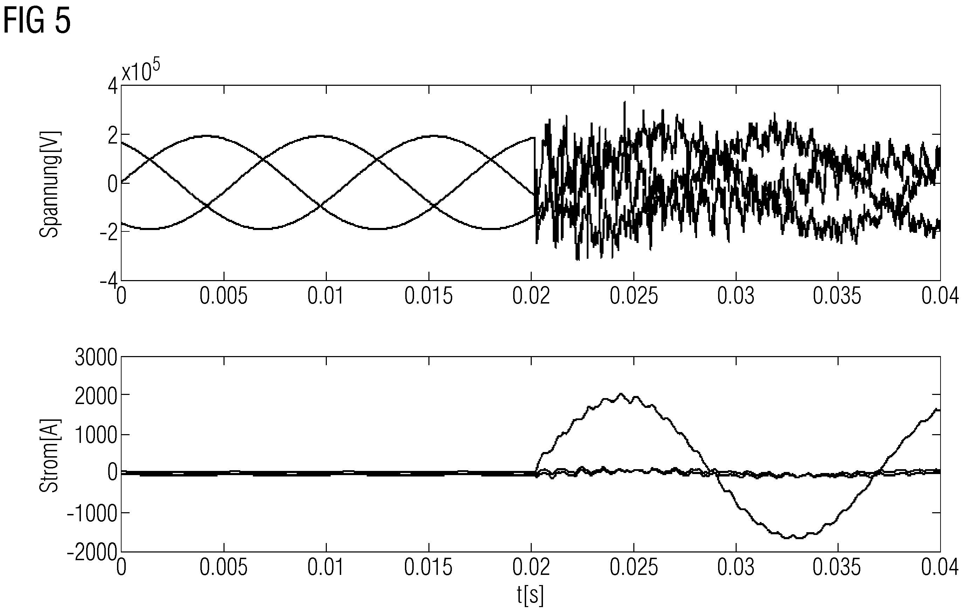

In Schritten 40a und 40b werden zunächst an beiden Leitungsenden jeweils die lokalen Ströme und Spannungen gemessen und entsprechende Strom- und Spannungsmesswerte erzeugt. Diese Messwerte liegen als Abtastwerte der Strom- und Spannungssignale der Leitung 11 vor. Ein Beispiel für die erfassten Strom- und Spannungsmesswerte ist in Figur 5 ersichtlich; Man erkennt einen Fehlereintritt bei etwa t=0,02s.

Damit nur die hochfrequenten transienten Anteile (Wanderwellen) der jeweiligen Strom- bzw. Spannungsmesswerte erfasst werden, kann optional in Schritten 41a und 41b jeweils eine Filterung (z.B. durch einen Bandpassfilter) stattfinden. Durch die Wahl der Eckfrequenzen z.B. des Bandpassfilters kann das Verfahren an die Eigenschaften der Wandler 13a, 13b und 14a, 14b angepasst werden. Stellen diese Wandler nur eine mittlere Bandbreite, z.B. nur bis 10kHz, zur Verfügung, dann müssen die Filter die Bandbreite der Signale auf die Bandbreite der Wandler begrenzen. Je nach Phasenfehler der eingesetzten Wandler ist dann mit einer etwas geringeren Messgenauigkeit zu rechnen. Können die Wandler eine höhere Bandbreite, z.B. bis 500kHz, bereitstellen, dann sollten die Filter entsprechend dimensioniert werden. Außerdem erweist es sich als vorteilhaft, wenn die Filtercharakteristik des zur Filterung der Strom- bzw. Spannungsmesswerte verwendeten Filters solche Frequenzanteile bedämpft, in denen die Messwandler 13 bzw. 14 Messfehler aufweisen.

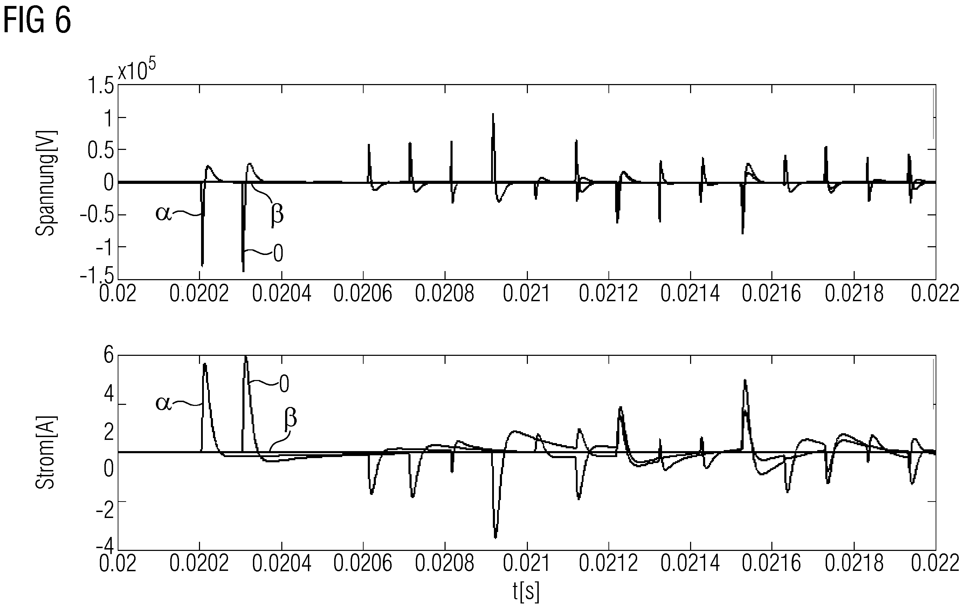

In Falle von dreiphasigen Energieversorgungsnetzen können zudem optional die jeweiligen Wanderwellen in Schritten 42a und 42b jeweils durch eine Transformation (z.B. Clarke-Transformation) behandelt werden, z.B. um die phasenbezogenen Anteile zu entkoppeln. Dabei werden transformierte gefilterte Strom- und Spannungswerte erzeugt, wie sie beispielhaft in Figur 6 gezeigt sind.

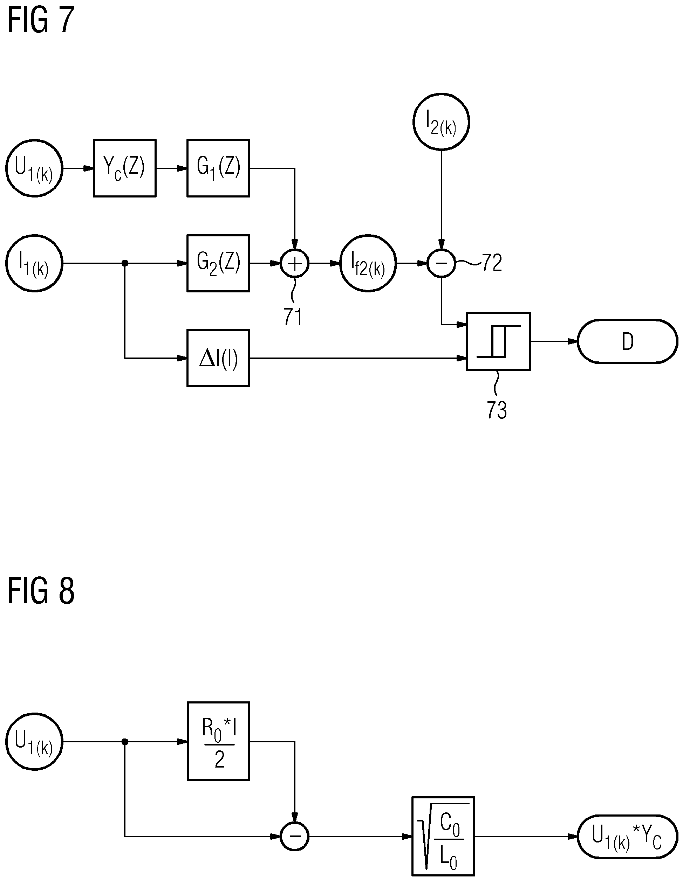

Um das Fehlerortungsverfahren nur bei Bedarf, d.h. im Fehlerfall, zu starten, findet in Schritten 43a und 43b die Positionierung eines Datenfensters statt, mit dem diejenigen Strom- und Spannungsmesswerte ausgewählt werden, die für die Fehlerortung herangezogen werden sollen. Die korrekte Positionierung des Datenfensters ist essentiell für eine genaue Fehlerortung. Die genaue Vorgehensweise bei der Datenfensterpositionierung wird später in Zusammenhang mit Figur 7 erläutert. Die in Figur 6 gezeigten Verläufe sind bereits auf das in den Schritten 43a und 43b ermittelte Datenfenster reduziert.

Falls die nachfolgende Auswertung im Frequenzbereich stattfinden soll, findet in Schritten 44a und 44b eine Überführung der transformierten Strom- und Spannungswerte in den Frequenzbereich statt. Dies erfolgt bevorzugt mittels einer Fast Fourier Transformation (FFT) bzw. Discrete Fourier Transformation (DFT).

Wie durch die Pfeile zwischen den Blöcken der Schritte 44a und 44b angedeutet, werden die sich ergebenden Werte zwischen den Einrichtungen 15a und 15b (vgl. Figuren 1 und 2) ausgetauscht. Dies erfolgt über die Kommunikationsverbindung 16 oder das Weitbereichsnetzwerk 24.

Mit den eigenen Werten und den Werten vom jeweils anderen Leitungsende führen die Einrichtungen 15a und 15b dann in Schritten 45a und 45b jeweils eine Fehlerortsuche nach dem Wanderwellenprinzip durch. Findet eine Auswertung im Zeitbereich statt, können stattdessen die Daten im Zeitbereich ausgetauscht und ausgewertet werden. Aus der Auswertung ergibt sich schließlich der Fehlerort x.

In Schritt 46 wird dann der ermittelte Fehlerort ausgegeben. Gemäß Figur 4 findet dies in einem gemeinsamen Ausgabeschritt statt. Stattdessen kann auch eine separate Ausgabe durch jede der beiden Einrichtungen 15a bzw. 15b erfolgen. Dabei kann jede der Einrichtungen 15a bzw. 15b ihren eigenen Fehlerort ausgeben, oder es kann ein (endgültiger) Fehlerort durch geeignete Verknüpfung der von den Einrichtungen 15a und 15b jeweils ermittelten Fehlerorte bestimmt werden.

Die Einrichtungen 15a und 15b besitzen üblicherweise eine Recheneinrichtung, in der die Schritte 40a/b bis 46 durchgeführt werden. Dabei kann es sich z.B. um einen Mikroprozessor handeln, der auf eine entsprechende Gerätesoftware zugreift, die sich in einem Speicher der jeweiligen Einrichtung befindet. Alternativ kann es sich auch um einen Rechenbaustein mit hardwarebestimmter Programmierung handeln, z.B. einen ASIC oder FPGA.

Nachfolgend wird eine Vorgehensweise erläutert, mit der das für die Auswertung der Strom- und Spannungswerte erforderliche Datenfenster möglichst genau positioniert werden kann. Diese Positionierung ist Voraussetzung für eine möglichst genaue Fehlerortung.

Durch Umstellung der Gleichungen (15) und (16), wobei als Bezugsort der Beginn der Leitung und für den Parameter x (Entfernung x vom Bezugsort) die gesamte Leitungslänge l gewählt wird, entsteht folgender Gleichungssatz (17):

$$\begin{pmatrix} U_2(s) \\ I_2(s) \end{pmatrix} = \begin{pmatrix} \cosh(\gamma(s) \cdot l) & Z_c(s) \cdot \sinh(\gamma(s) \cdot l) \\ \dfrac{1}{Z_c(s)} \cdot \sinh(\gamma(s) \cdot l) & \cosh(\gamma(s) \cdot l) \end{pmatrix} \cdot \begin{pmatrix} U_1(s) \\ I_1(s) \end{pmatrix} \qquad (17)$$

Dieser Gleichungssatz (17) beschreibt im Frequenzbereich, wie die Signale $U_2$ und $I_2$ des zweiten Leitungsendes aus den Signalen $U_1$ und $I_1$ des ersten Leitungsendes berechnet werden können.

Um die Signale aus den Abtastwertefolgen ermitteln zu können, kann eine Transformation der Gleichungen in den z- Bereich erfolgen. Das wird exemplarisch an der Prädiktionsgleichung zur Ermittlung des geschätzten Stromes $I_{f2}(s)$ am zweiten Leitungsende aus den Strom- und Spannungssignalen $I_1(s)$ und $U_1(s)$ des ersten Leitungsendes gezeigt:

$$I_{f2}(z) = Y_c(z) * G_1(z) * U_1(z) + G_2(z) * I_1(z) \qquad (18)$$

Die in Gleichung (18) verwendeten Übertragungsfunktionen sind hierbei wie folgt definiert:

$$G_1(z) = F^{-1}\{\sinh(\gamma(s) \cdot l)\} \qquad (19)$$

$$G_2(z) = F^{-1}\{\cosh(\gamma(s) \cdot l)\} \qquad (20)$$

$$Y_c(z) = F^{-1}\left\{\frac{1}{Z_c(z)}\right\} \qquad (21)$$

Vorteilhaft lassen sich die die Ausbreitungskonstante $\gamma$ berücksichtigenden Übertragungsfunktionen $G_1(z)$ und $G_2(z)$ durch ein FIR-Filter und die die Wellenimpedanz $Z_c$ berücksichtigende Übertragungsfunktion $Y_c(z)$ durch ein IIR-Filter abbilden. Somit kann der geschätzte Strom des zweiten Endes der Leitung aus dem Strom- und Spannungssignal vom ersten Leitungsende mithilfe einer logischen Anordnung wie in Figur 7 dargestellt bestimmt werden. Die logische Anordnung gemäß Figur 7 kann dabei in Form einer Hardware oder einer von einem Prozessor ausgeführten Software in den Einrichtungen 15a implementiert sein. Der geschätzte Strom $I_{f2}$ des zweiten Leitungsendes wird aus den am ersten Leitungsende gemessenen Strom- und Spannungswerten $I_1$ und $U_1$ durch Anwendung der Übertragungsfunkti-

onen $G_1(z)$ und $G_2(z)$ sowie $Y_c(z)$ (z.B. durch Filterung) und Addition in einem Addierer 71 gebildet.

Die geschätzten zweiten Stromwerte $I_{f2}$ werden daraufhin in einem Subtrahierer 72 durch Differenzbildung mit den am zweiten Leitungsende tatsächlich gemessenen Stromwerten $I_2$ verglichen. In einem Schwellenwertglied 73 findet ein Vergleich der resultierenden Differenz mit einem Schwellenwert statt. Bei Überschreitung des Schwellenwertes wird ein Signal D gebildet, das einen Fehler auf der Leitung anzeigt. Dieses Signal D definiert das für eine Fehlerortung zu verwendende Datenfenster, indem derjenige Zeitpunkt, zu dem das Signal D erstmalig auftritt, als Beginn des Datenfensters festgelegt wird.

Die Länge des Datenfensters kann fest vorgegeben sein oder variabel bestimmt werden. Bei einer festen Vorgabe sollte die Länge des Datenfensters bevorzugt mindestens das Vierfache der Propagationszeit der Wanderwelle in der ausgewählten Modalkomponente betragen, damit alle zur Fehlerortung benötigten Wellenphänomene im Datenfenster berücksichtigt werden. Bei variabler Bestimmung kann die Länge des Datenfensters an das Vorliegen des Signals D (und damit an die Dauer des Fehlers auf der Leitung) gekoppelt sein.

Der im Schwellenwertglied verwendete Schwellenwert kann beispielsweise an die Höhe des Stroms $I_1$ am ersten Leitungsende angepasst sein. Der Block $\Delta I(I)$ in Figur 7 bildet hierfür für einen aktuellen (k-ten) Strom-Abtastwert $I_k$ einen Schwellenwert $I_S(k)$, der für den Schwellwertvergleich im Schwellenwertglied 73 benutzt wird. Dieser Stabilisierungswert kann z.B. mittels folgender Gleichung (22) gebildet werden:

$$I_S(k) = 0{,}08 \cdot \frac{1}{N} \sqrt{\sum_{i=0}^{N} i^2{}_{(k-i)}} + 0{,}02 \qquad (22)$$

Die Übertragungsfunktion $Y_c(z)$ kann z.B. mittels eines Least Squares Schätzers aus dem Frequenzgang der Wellenimpedanz $Z_c$ berechnet werden. Kann auf eine Modellierung der Frequenzabhängigkeit der Parameter Induktivitätsbelag $L_0$, Kapazitätsbelag $C_0$, Widerstandsbelag $R_0$ sowie Konduktivitätsbelag $G_0$ verzichtet werden und kann der Leitwert Konduktivitätsbelag $G_0$ als sehr klein angenommen werden (das ist für Frequenzen unterhalb von 50kHz und Freileitungen üblicherweise der Fall), dann kann das für die logische Anordnung in Figur 7 benötigte Faltungsprodukt von $Y_c$ mit der lokalen Spannung der Leitung auch mit einer logischen Anordnung gebildet werden, wie sie in Figur 8 dargestellt ist.

Die Übertragungsfunktionen $G_1$ und $G_2$ können zudem aus den Termen der hyperbolischen Funktionen mit dem Argument $\gamma \cdot l$ durch inverse FFT gebildet werden.

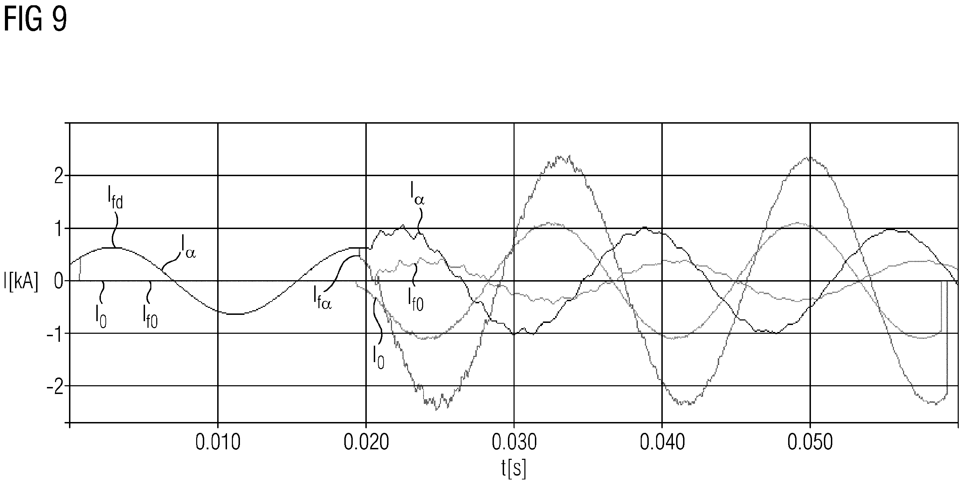

Figur 9 zeigt den mittels der Strom- und Spannungswerte am ersten Leitungsende berechneten geschätzten Strom sowie das am zweiten Leitungsende tatsächlich gemessene Stromsignal. Man erkennt, dass für den Zeitraum, in dem die Leitung fehlerfrei ist, die geschätzten (berechneten) und die gemessenen zweiten Stromwerte vollständig übereinstimmen, während bei anstehendem Fehler eine signifikante Abweichung sichtbar ist. Dieses Verhalten wird wie beschrieben zur Positionierung des Datenfensters verwendet.

In der Einrichtung 15b ist eine entsprechende Logik implementiert, um den Strom am ersten Leitungsende zu ermitteln und in entsprechender Weise das Datenfenster zur Fehlerortung festzulegen, so dass die hinsichtlich des ersten Leitungsendes beschriebenen Ausführungen in entsprechender Weise auch für das zweite Leitungsende gelten.

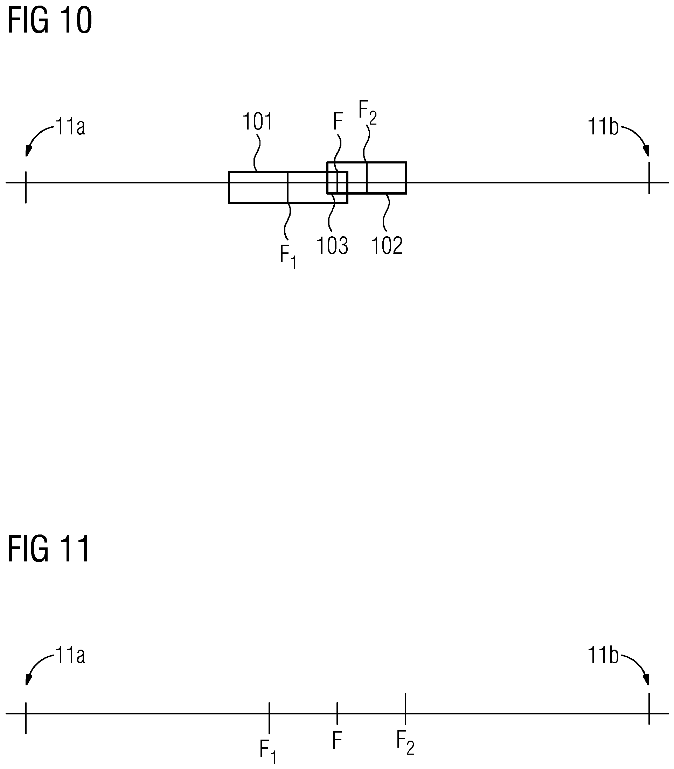

Figur 10 zeigt eine Möglichkeit, wie aus einem am ersten Leitungsende 11a mit der Einrichtung 15a bestimmten ersten Fehlerort $F_1$ und einem am zweiten Leitungsende 11b mit der Einrichtung 15b bestimmten zweiten Fehlerort $F_2$ ein endgültiger Fehlerort F ermittelt werden kann.

Gemäß dem Ausführungsbeispiel in Figur 10 werden sowohl der erste Fehlerort als auch der zweite Fehlerort nicht als singulärer Punkt, sondern als Bereich angegeben. Dies kann beispielsweise dadurch erfolgen, dass dem berechneten Fehlerort ein Toleranzbereich zugeordnet wird, der z.B. mögliche Fehler bei der Messung und/oder Datenverarbeitung berücksichtigt. So ist gemäß Figur 10 dem ersten Fehlerort $F_1$ ein Wertebereich 101 zugeordnet, während dem zweiten Fehlerort $F_2$ ein Wertebereich 102 zugeordnet ist. Die Wertebereiche 101 und 102 können dabei identische oder voneinander abweichende Größen haben. Der endgültige Fehlerort F wird in der Mitte des Überschneidungsbereichs 103 der beiden Wertebereiche 101 und 102 festgelegt.

Figur 11 zeigt schließlich eine alternative Vorgehensweise zur Festlegung des endgültigen Fehlerortes F aus dem ersten Fehlerort $F_1$ und dem zweiten Fehlerort $F_2$. Gemäß Figur 11 wird der Fehlerort F durch Mittelwertbildung aus dem ersten Fehlerort $F_1$ und dem zweiten Fehlerort $F_2$ gebildet.

Voranstehend wurde somit eine Vorgehensweise beschrieben, wie zur Gewährleistung einer möglichst exakten Fehlerortung nach dem Wanderwellenprinzip ein Datenfenster mit hoher Genauigkeit positioniert werden kann. Dabei werden nicht wie im Stand der Technik üblich Triggersignale einer Schutzfunktion für die Datenfensterbestimmung herangezogen werden, sondern es werden z.B. unter Anwendung eines Leitungsmodells der nicht fehlerbehafteten Leitung aus den Strom- und Spannungswerten vom einen Leitungsende geschätzte Stromwerte am anderen Leitungsende bestimmt. Diese geschätzten Stromwerte stimmen erfindungsgemäß für den Fall, dass die Leitung keinen Fehler aufweist, mit den gemessenen Stromwerten am zweiten Leitungsende überein. Der Zeitraum, in denen sich die Signale unterscheiden, entspricht damit demjenigen Zeitraum, in dem die Leitung fehlerbehaftet ist.

Das Verfahren lässt sich in Verbindung mit einer Einrichtung zur zweiseitigen Wanderwellen- Fehlerortung einsetzen.

Obwohl die Vorgehensweise zur Datenfensterpositionierung voranstehend in Bezug auf geschätzte Stromwerte am anderen Leitungsende beschrieben worden ist, lässt sich das Verfahren auch in entsprechender Weise durch Ermittlung geschätzter Spannungswerte und Vergleich mit den entsprechenden gemessenen Spannungswerten durchführen.

In Figuren 1 und 2 wurde ein System zum Ermitteln eines Fehlerortes gezeigt, bei dem der Fehlerort mit zwei Einrichtungen 15a und 15b ermittelt wird, die sich jeweils an einem Leitungsende 11a bzw. 11b befinden. Stattdessen kann auch eine zentrale Einrichtung vorgesehen sein, der die Strom- und Spannungsmesswerte von den Leitungsenden zugeführt werden.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

**Patentansprüche**

1. Verfahren zum Ermitteln des Fehlerortes eines Fehlers auf einer Leitung (11) eines elektrischen Energieversorgungsnetzes, bei dem

   - an einem ersten Leitungsende (11a) der Leitung (11) erste Strom- und Spannungswerte gemessen und mit einem Zeitstempel versehen werden;
   - an einem zweiten Leitungsende (11b) der Leitung (11) zweite Strom- und Spannungswerte gemessen und mit einem Zeitstempel versehen werden; und
   - unter Verwendung der zeitgestempelten ersten und zweiten Strom- und Spannungswerte nach dem Auftreten eines Fehlers auf der Leitung (11) dessen Fehlerort bestimmt wird;
   **dadurch gekennzeichnet, dass**
   - mit den an dem ersten Leitungsende (11a) gemessenen ersten Strom- und Spannungswerten geschätzte zweite Strom- oder Spannungswerte bestimmt werden, die den am zweiten Leitungsende (11b) fließenden Strom oder die am zweiten Leitungsende (11b) anliegende Spannung angeben;
   - die geschätzten zweiten Strom- oder Spannungswerte mit den am zweiten Leitungsende (11b) gemessenen zweiten Strom- oder Spannungswerten verglichen werden; und
   - zur Bestimmung eines ersten Fehlerortes solche erste und zweite Strom- und Spannungswerte herangezogen werden, die innerhalb einer durch ein erstes Datenfenster festgelegten Zeitdauer liegen, wobei der Beginn des ersten Datenfensters in Abhängigkeit von demjenigen Zeitpunkt festgesetzt wird, zu dem eine Abweichung zwischen den geschätzten zweiten Strom- oder Spannungswerten und den gemessenen zweiten Strom- oder Spannungswerten erkannt wird.

2. Verfahren nach Anspruch 1,
   **dadurch gekennzeichnet, dass**

   - zum Erkennen einer Abweichung zwischen den geschätzten zweiten Strom- oder Spannungswerten und den gemessenen zweiten Strom- oder Spannungswerten die Differenz aus den geschätzten zweiten Strom- oder Spannungswerten und den gemessenen zweiten Strom- oder Spannungswerten gebildet wird; und
   - eine Abweichung dann erkannt wird, wenn der Betrag der Differenz einen ersten Schwellenwert überschreitet, wobei der erste Schwellenwert in Abhängigkeit von der Höhe des am ersten Leitungsende (11a) fließenden Stroms gewählt wird.

3. Verfahren nach Anspruch 1 oder 2,
   **dadurch gekennzeichnet, dass**

   - zur Bestimmung der geschätzten zweiten Strom- oder Spannungswerte ein mathematisches Modell der Leitung (11) für den fehlerfreien Fall herangezogen wird.

4. Verfahren nach Anspruch 3,

**dadurch gekennzeichnet, dass**

- zur Bestimmung der geschätzten zweiten Strom- oder Spannungswerte die ersten Strom- und Spannungswerte einer Filterung unterzogen werden, wobei mit dem Filter eine zumindest von der Ausbreitungskonstante einer Wanderwelle entlang der Leitung (11) abhängige Übertragungsfunktion nachgebildet wird.

5. Verfahren nach Anspruch 4,
**dadurch gekennzeichnet, dass**

- bei der Filterung der ersten Spannungswerte zusätzlich ein Filter verwendet wird, mit dem eine von der Wellenimpedanz der Leitung (11) abhängige Übertragungsfunktion nachgebildet wird.

6. Verfahren nach einem der vorangehenden Ansprüche,
**dadurch gekennzeichnet, dass**

- es sich bei den für die Ermittlung des ersten Fehlerortes herangezogenen Strom- und Spannungswerten um abgespeicherte Strom- und Spannungswerte handelt.

7. Verfahren nach einem der Ansprüche 1 bis 5,
**dadurch gekennzeichnet, dass**

- es sich bei den für die Ermittlung des ersten Fehlerortes herangezogenen Strom- und Spannungswerten unmittelbar um jeweils aktuell gemessene Strom- und Spannungswerte handelt.

8. Verfahren nach einem der vorangehenden Ansprüche,
**dadurch gekennzeichnet, dass**

- ein Datenfenster mit einer festgelegten Länge verwendet wird.

9. Verfahren nach einem der Ansprüche 1 bis 7,
**dadurch gekennzeichnet, dass**

- ein Datenfenster mit einer variablen Länge verwendet wird, wobei das Ende des Datenfensters in Abhängigkeit von demjenigen Zeitpunkt festgelegt wird, zu dem zu dem keine Abweichung mehr zwischen den geschätzten zweiten Strom- oder Spannungswerten und den gemessenen zweiten Strom- oder Spannungswerten erkannt wird.

10. Verfahren nach einem der vorangehenden Ansprüche,
**dadurch gekennzeichnet, dass**

- mit den an dem zweiten Leitungsende (11b) gemessenen zweiten Strom- und Spannungswerten geschätzte erste Strom- oder Spannungswerte berechnet werden, die den am ersten Leitungsende (11a) fließenden Strom oder die am ersten Leitungsende (11a) anliegende Spannung angeben;
- die geschätzten ersten Strom- oder Spannungswerte mit den am ersten Leitungsende (11a) gemessenen ersten Strom- oder Spannungswerten verglichen werden; und
- zur Bestimmung eines zweiten Fehlerortes solche erste und zweite Strom- und Spannungswerte herangezogen werden, die innerhalb einer durch ein zweites Datenfenster festgelegten Zeitdauer liegen, wobei der Beginn des zweiten Datenfensters auf denjenigen Zeitpunkt festgesetzt wird, zu dem eine Abweichung zwischen den geschätzten ersten Strom- oder Spannungswerten und den gemessenen ersten Strom- oder Spannungswerten erkannt wird.

11. Verfahren nach Anspruch 10,
**dadurch gekennzeichnet, dass**

- der Fehlerort des auf der Leitung (11) aufgetretenen Fehlers unter Verwendung des ersten Fehlerortes und des zweiten Fehlerortes bestimmt wird.

12. Verfahren nach Anspruch 11,

**dadurch gekennzeichnet, dass**

- der Fehlerort des auf der Leitung (11) aufgetretenen Fehlers durch Mittelwertbildung aus dem ersten Fehlerort und dem zweiten Fehlerort gebildet wird.

13. Einrichtung (15a) zum Ermitteln des Fehlerortes eines Fehlers auf einer Leitung (11) eines elektrischen Energieversorgungsnetzes mit

- einer Recheneinrichtung (17a), die dazu eingerichtet ist, unter Verwendung von an einem ersten Leitungsende (11a) der Leitung (11) gemessenen und zeitgestempelten ersten Strom- und Spannungswerten und an einem zweiten Leitungsende (11b) der Leitung (11) gemessenen und zeitgestempelten zweiten Strom- und Spannungswerten nach dem Auftreten eines Fehlers auf der Leitung dessen Fehlerort zu bestimmen;
**dadurch gekennzeichnet, dass**
- die Recheneinrichtung (17a) dazu eingerichtet ist, mit den an dem ersten Leitungsende (11a) gemessenen ersten Strom- und Spannungswerten geschätzte zweite Strom- oder Spannungswerte zu bestimmen, die den am zweiten Leitungsende (11b) fließenden Strom oder die am zweiten Leitungsende (11b) anliegende Spannung angeben;
- die Recheneinrichtung (17a) dazu eingerichtet ist, die geschätzten zweiten Strom- oder Spannungswerte mit den am zweiten Leitungsende (11b) gemessenen zweiten Strom- oder Spannungswerten zu vergleichen; und
- die Recheneinrichtung (17a) dazu eingerichtet ist, zur Bestimmung eines ersten Fehlerortes solche erste und zweite Strom- und Spannungswerte heranzuziehen, die innerhalb einer durch ein erstes Datenfenster festgelegten Zeitdauer liegen, wobei der Beginn des ersten Datenfensters auf denjenigen Zeitpunkt festgesetzt wird, zu dem eine Abweichung zwischen den geschätzten zweiten Strom- oder Spannungswerten und den gemessenen zweiten Strom- oder Spannungswerten erkannt wird.

14. Einrichtung (15a) nach Anspruch 13,
**dadurch gekennzeichnet, dass**

- die Einrichtung (15a) ein elektrisches Schutzgerät oder Teil eines elektrischen Schutzgerätes ist.

15. Einrichtung (15a) nach Anspruch 13,
**dadurch gekennzeichnet, dass**

- die Einrichtung (15a) ein Datenkonzentrator einer Schaltanlage des elektrischen Energieversorgungsnetzes ist.

16. System (10) zum Ermitteln des Fehlerortes eines Fehlers auf einer Leitung (11) eines elektrischen Energieversorgungsnetzes, mit einer nach einem der Ansprüche 13 bis 15 ausgebildeten Einrichtung (15a),
**dadurch gekennzeichnet, dass**

- eine zweite Einrichtung (15b) vorgesehen ist, die eine Recheneinrichtung (17b) aufweist, wobei
- die Recheneinrichtung (17b) der zweiten Einrichtung (15b) dazu eingerichtet ist, mit den an dem zweiten Leitungsende (11b) gemessenen zweiten Strom- und Spannungswerten geschätzte erste Strom- oder Spannungswerte zu bestimmen, die den am ersten Leitungsende (11a) fließenden Strom oder die am ersten Leitungsende (11a) anliegende Spannung angeben;
- die Recheneinrichtung (17b) der zweiten Einrichtung (15b) dazu eingerichtet ist, die geschätzten ersten Strom- oder Spannungswerte mit den am ersten Leitungsende (11a) gemessenen ersten Strom- oder Spannungswerten zu vergleichen;
- die Recheneinrichtung (17b) der zweiten Einrichtung (15b) dazu eingerichtet ist, zur Bestimmung eines zweiten Fehlerortes solche erste und zweite Strom- und Spannungswerte heranzuziehen, die innerhalb einer durch ein zweites Datenfenster festgelegten Zeitdauer liegen, wobei der Beginn des zweiten Datenfensters auf denjenigen Zeitpunkt festgesetzt wird, zu dem eine Abweichung zwischen den geschätzten ersten Strom- oder Spannungswerten und den gemessenen ersten Strom- oder Spannungswerten erkannt wird; und
- die Recheneinrichtung (17a) der ersten Einrichtung (15a) und/oder die Recheneinrichtung (17b) der zweiten Einrichtung (15b) dazu eingerichtet sind, den Fehlerort unter Verwendung des ersten Fehlerortes und des zweiten Fehlerortes zu bestimmen.

**Claims**

1. Method for determining the fault position of a fault on a line (11) of an electrical power supply network, in which

    - first current and voltage values are measured at a first line end (11a) of the line (11) and provided with a time stamp;
    - second current and voltage values are measured at a second line end (11b) of the line (11) and provided with a time stamp; and
    - by using the time-stamped first and second current and voltage values after the occurrence of a fault on the line (11), the fault position of the latter is determined; **characterized in that**
    - with the first current and voltage values measured at the first line end (11a), second current and voltage values are determined, which indicate the current flowing at the second line end (11b) or the voltage applied at the second line end (11b);
    - the estimated second current or voltage values are compared with the current or voltage values measured at the second line end (11b); and
    - first and second current and voltage values that lie within a period of time established by a first data window are employed in order to determine a first fault position, the start of the first data window being established as a function of the time at which a discrepancy is identified between the estimated second current or voltage values and the measured second current or voltage values.

2. Method according to Claim 1,
    **characterized in that**

    - in order to identify a discrepancy between the estimated second current or voltage values and the measured second current or voltage values, the difference between the estimated second current or voltage values and the measured second current or voltage values is formed; and
    - a discrepancy is identified when the magnitude of the difference exceeds a first threshold value, the first threshold value being selected as a function of the strength of the current flowing at the first line end (11a).

3. Method according to Claim 1 or 2,
    **characterized in that**

    - a mathematical model of the line (11) for the fault-free case is employed in order to determine the estimated second current or voltage values.

4. Method according to Claim 3,
    **characterized in that**

    - the first current and voltage values are subjected to filtering in order to determine the estimated second current or voltage values, a transfer function dependent at least on the propagation constant of a traveling wave along the line (11) being replicated by the filter.

5. Method according to Claim 4,
    **characterized in that**

    - a filter, with which a transfer function dependent on the characteristic impedance of the line (11) is replicated, is additionally used in the filtering of the first voltage values.

6. Method according to one of the preceding claims, **characterized in that**

    - the current and voltage values employed for determining the first fault position are stored current and voltage values.

7. Method according to one of Claims 1 to 5,
    **characterized in that**

    - the current and voltage values employed for determining the first fault position are directly each instantaneously measured current and voltage values.

**8.** Method according to one of the preceding claims, **characterized in that**

- a data window with an established length is used.

**9.** Method according to one of Claims 1 to 7,
**characterized in that**

- a data window with a variable length is used, the end of the data window being established as a function of the time at which a deviation is no longer identified between the estimated second current or voltage values and the measured second current or voltage values.

**10.** Method according to one of the preceding claims, **characterized in that**

- with the current and voltage values measured at the second line end (11b), estimated first current or voltage values are calculated, which indicate the current flowing at the first line end (11a) or the voltage applied at the first line end (11a);
- the estimated first current or voltage values are compared with the current or voltage values measured at the first line end (11a); and
- first and second current and voltage values that lie within a period of time established by a second data window are employed in order to determine a first fault position, the start of the second data window being established as a function of the time at which a discrepancy is identified between the estimated first current or voltage values and the measured first current or voltage values.

**11.** Method according to Claim 10,
**characterized in that**

- the fault position of the fault occurring on the line (11) is determined by using the first fault position and the second fault position.

**12.** Method according to Claim 11,
**characterized in that**

- the fault position of the fault occurring on the line (11) is determined by averaging from the first fault position and the second fault position.

**13.** Device (15a) for determining the fault position of a fault on a line (11) of an electrical power supply network, having

- a computing device (17a), which is configured, by using first current and voltage values measured at a first line end (11a) of the line (11) and time stamped, and second current and voltage values measured at a second line end (11b) and time, after the occurrence of a fault on the line (11), to determine the fault position of the latter; **characterized in that**
- the computing device (17a) is configured to determine, with the first current and voltage values measured at the first line end (11a), to determine estimated current or voltage values which indicate the current flowing at the second line end (11b) or the voltage applied at the second line end (11b);
- the computing device (17a) is configured to compare the estimated second current or voltage values with the second current or voltage values measured at the second line end (11b);
- the computing device (17a) is configured, in order to determine the first fault position, to use current and voltage values that lie within a period of time established by a first data window are employed in order to determine a first fault position, the start of the first data window being established as a function of the time at which a discrepancy is identified between the estimated second current or voltage values and the measured second current or voltage values.

**14.** Device (15a) according to Claim 13,
**characterized in that**

- the device (15a) is an electrical protection apparatus or part of an electrical protection apparatus.

**15.** Device (15a) according to Claim 13,

**characterized in that**

- the device (15a) is a data concentrator of a switchgear of the electrical power supply network.

**16.** System (10) for determining the fault position of a fault on a line (11) of an electrical power supply network, having a device (15a) configured according to one of Claims 13 to 15, **characterized in that**

- a second device (15b) is provided, which comprises a computing device (17b), wherein
- the computing device (17b) of the second device (15b) is configured to determine, with the current and voltage values measured at the second line end (11b), estimated first current or voltage values which indicate the current flowing at the first line end (11a) or the voltage applied at the first line end (11a);
- the computing device (17b) of the second device (15b) is configured to compare the estimated first current or voltage values with the first current or voltage values measured at the first line end (11a);
- the computing device (17b) of the second device (15b) is configured, in order to determine a second fault position, to employ second current and voltage values that lie within a period of time established by a second data window are employed in order to determine a first fault position, the start of the second data window being established as a function of the time at which a discrepancy is identified between the estimated first current or voltage values and the measured first current or voltage values; and
- the computing device (17a) of the first device (15a) and/or the computing device (17b) of the second device (15b) our determined to determine the fault position by using the first fault position and the second fault position.

**Revendications**

**1.** Procédé de détermination de l'endroit d'un défaut sur une ligne (11) d'un réseau d'alimentation en énergie électrique, dans lequel

- on mesure de premières valeurs de courant et de tension à un premier bout (11a) de la ligne (11) et on les munit d'un horodatage;
- on mesure des deuxièmes valeurs de courant et de tension à un second bout (11b) de la ligne (11) et on les munit d'un horodatage ; et
- en utilisant les première et deuxième valeurs de courant et de tension horodatées, on détermine l'endroit d'un défaut après son apparition sur la ligne (11) ;
**caractérisé en ce que**
- on détermine, par les premières valeurs de courant et de tension mesurées au premier bout (11a) de la ligne, des deuxièmes valeurs de courant et de tension estimées, qui indiquent le courant passant au deuxième bout (11b) de la ligne ou la tension s'appliquant au deuxième bout (11b) de la ligne ;
- on compare les deuxième valeurs de courant et de tension estimées aux deuxièmes valeurs de courant et de tension mesurées au deuxième bout (11b) de la ligne ; et
- pour déterminer un premier endroit de défaut, on tire parti des premières et deuxièmes valeurs de courant et de tension qui sont dans une durée fixée par une première fenêtre de dates, le début de la première fenêtre de dates étant fixé en fonction de l'instant où on reconnaît un écart entre les deuxièmes valeurs de courant et de tension estimées et les deuxièmes valeurs de courant et de tension mesurées.

**2.** Procédé suivant la revendication 1,
**caractérisé en ce que**

- pour reconnaître un écart entre les deuxièmes valeurs de courant et de tension estimées et les deuxièmes valeurs de courant et de tension mesurées, on forme la différence entre les deuxièmes valeurs de courant et de tension estimées et les deuxièmes valeurs de tension et de courant mesurées ; et
- on reconnaît un écart, si la valeur absolue de différence dépasse une première valeur de seuil, la première valeur de seuil étant choisie en fonction de l'intensité du courant passant au premier bout (11a) de la ligne.

**3.** Procédé suivant la revendication 1 ou 2,
**caractérisé en ce que**

- pour déterminer les deuxièmes valeurs de courant ou de tension estimées, on tire parti d'un modèle mathématique de la ligne (11), dans le cas où il n'y a pas de défaut.

**4.** Procédé suivant la revendication 3,
**caractérisé en ce que**

- pour déterminer les deuxièmes valeurs de courant et de tension estimées, on soumet les premières valeurs de courant et de tension à un filtrage, dans lequel on simule, par le filtre, une fonction de transfert, qui dépend de la constante de propagation d'une onde progressive dans la ligne (11).

**5.** Procédé suivant la revendication 4,
**caractérisé en ce que**

- pour le filtrage des premières valeurs de tension, on utilise, en outre, un filtre, par lequel on simule une fonction de transfert, qui dépend de l'impédance d'onde de la ligne (11).

**6.** Procédé suivant l'une des revendications précédentes, **caractérisé en ce que**

- les valeurs de courant et de tension, mises à profit pour la détermination du premier endroit de défaut, sont des valeurs de courant et de tension mises en mémoire.

**7.** Procédé suivant l'une des revendications 1 à 5, **caractérisé en ce que**

- les valeurs de courant et de tension, mises à profit pour la détermination du premier endroit de défaut, sont des valeurs de courant et de tension mesurées instantanément directement.

**8.** Procédé suivant l'une des revendications précédentes, **caractérisé en ce que**

- on utilise une fenêtre de dates d'une longueur fixée.

**9.** Procédé suivant l'une des revendications 1 à 7, **caractérisé en ce que**

- on utilise une fenêtre de dates d'une longueur variable, la fin de la fenêtre de dates étant fixée en fonction de l'instant où on ne reconnaît plus d'écart entre les deuxièmes valeurs de courant et de tension estimées et les deuxièmes valeurs de courant et de tension mesurées.

**10.** Procédé suivant l'une des revendications précédentes, **caractérisé en ce que**

- par les deuxièmes valeurs de courant et de tension mesurées au deuxième bout (11b) de la ligne, on calcule des premières valeurs de courant et de tension estimées, qui indiquent le courant passant dans le premier bout (11a) de la ligne ou la tension s'appliquant au premier bout (11a) de la ligne;
- on compare les premières valeurs de courant et de tension estimées aux premières valeurs de courant ou de tension mesurées au premier bout (11a) de la ligne ; et
- pour déterminer un deuxième endroit de défaut, on tire parti des premières et deuxièmes valeurs de courant et de tension qui sont dans une durée fixée par une deuxième fenêtre de dates, le début de la deuxième fenêtre de dates étant fixé à l'instant où on reconnaît un écart entre les premières valeurs de tension et de courant estimées et les premières valeurs de courant et de tension mesurées.

**11.** Procédé suivant la revendication 10,
**caractérisé en ce que**

- on détermine l'endroit du défaut apparu sur la ligne (11) en utilisant le premier endroit de défaut et le deuxième endroit de défaut.

**12.** Procédé suivant la revendication 11,
**caractérisé en ce que**

- on détermine l'endroit du défaut apparu sur la ligne (11) en faisant la moyenne du premier endroit du défaut et du deuxième endroit du défaut.

**13.** Dispositif (15a) de détermination de l'endroit d'un défaut sur une ligne (11) d'un réseau d'alimentation en énergie électrique, comprenant

- un dispositif (17a) de calcul, conçu pour déterminer un endroit du défaut après son apparition sur la ligne, en utilisant des premières valeurs de courant et de tension horodatées et mesurées à un premier bout (11a) de la ligne (11) et des deuxièmes valeurs de courant et de tension horodatées et mesurées à un deuxième bout (11b) de la ligne (11) ;

**caractérisé en ce que**

- le dispositif (17a) de calcul est conçu pour déterminer, par les premières valeurs de courant et de tension mesurées au premier bout (11a) de la ligne, des deuxièmes valeurs de courant ou de tension estimées, qui indiquent le courant passant dans le deuxième bout (11b) de la ligne ou la tension s'appliquant au deuxième bout (11b) de la ligne ;

- le dispositif (17a) de calcul est conçu pour comparer les deuxièmes valeurs de courant ou de tension estimées aux deuxièmes valeurs de courant ou de tension mesurées au deuxième bout (11b) de la ligne ; et

- le dispositif (17a) de calcul est conçu pour tirer parti, pour la détermination d'un premier endroit de défaut, des premières et deuxièmes valeurs de courant et de tension, qui sont dans une durée fixée par une première fenêtre de dates, le début de la première fenêtre de dates étant fixé à l'instant où on reconnaît un écart entre les deuxièmes valeurs de courant ou de tension estimées et les deuxièmes valeurs de courant ou de tension mesurées.

14. Dispositif (15a) suivant la revendication 13, **caractérisé en ce que**

- le dispositif (15a) est un appareil de protection électrique ou une partie d'un appareil de protection électrique.

15. Dispositif (15a) suivant la revendication 13, **caractérisé en ce que**

- le dispositif (15a) est un concentrateur de données d'une installation de distribution du réseau d'alimentation en énergie électrique.

16. Système (10) de détermination de l'endroit d'un défaut sur une ligne (11) d'un réseau d'alimentation en énergie électrique, comprenant un dispositif (15a) constitué suivant l'une des revendications 13 à 15, **caractérisé en ce que**

- il est prévu un deuxième dispositif (15b), qui a un dispositif (17b) de calcul, dans lequel

- le dispositif (17b) de calcule du deuxième dispositif (15b) est conçu pour déterminer, par les deuxièmes valeurs de courant et de tension mesurées au deuxième bout (11b) de la ligne, des premières valeurs de courant ou de tension estimées, qui indiquent le courant passant dans le premier bout (11a) de la ligne ou la tension s'appliquant au premier bout (11a) de la ligne ;

- le dispositif (17b) de calcul du deuxième dispositif (15b) est conçu pour comparer les premières valeurs de courant ou de tension estimées aux premières valeurs de courant ou de tension mesurées au premier bout (11a) de la ligne ;

- le dispositif (17b) de calcul du deuxième dispositif (15b) est conçu pour tirer parti, pour la détermination d'un deuxième endroit de défaut, des premières et deuxièmes valeurs de courant et de tension, qui sont dans une durée fixée par une deuxième fenêtre de dates, le début de la deuxième fenêtre de dates étant fixé à l'instant où on reconnait un écart entre les premières valeurs de courant ou de tension estimées et les premières valeurs de courant ou de tension mesurées et

- le dispositif (17a) de calcul du premier dispositif (15a) et/ou le dispositif (17b) de calcul du deuxième dispositif (15b) sont conçus pour déterminer l'endroit du défaut, en utilisant le premier endroit du défaut et le deuxième endroit du défaut.

FIG 1

## FIG 2

## FIG 3

# FIG 4

FIG 5

EP 3 379 273 B1

FIG 6

EP 3 379 273 B1

FIG 7

FIG 8

FIG 9

FIG 10

FIG 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2476002 B1
- WO 2012126526 A1
- US 4996624 A
- US 5929642 A
- US 20060012374 A1
- US 2014074414 A
- US 2011109465 A
- US 2015081235 A
- CH 684660
- US 3590368 A
- US 4183072 A